(19) Europäisches Patentamt
European Patent Office
Office européen des brevets

(11) EP 1 854 803 A1

(12) EUROPEAN PATENT APPLICATION
published in accordance with Art. 158(3) EPC

(43) Date of publication:
14.11.2007 Bulletin 2007/46

(21) Application number: 06714685.2

(22) Date of filing: 27.02.2006

(51) Int Cl.:
*C07F 15/00* *(2006.01)* *C09K 11/06* *(2006.01)*
*H01L 51/50* *(2006.01)*

(86) International application number:
PCT/JP2006/303548

(87) International publication number:
WO 2006/093069 (08.09.2006 Gazette 2006/36)

(84) Designated Contracting States:
AT BE BG CH CY CZ DE DK EE ES FI FR GB GR HU IE IS IT LI LT LU LV MC NL PL PT RO SE SI SK TR

(30) Priority: 03.03.2005 JP 2005059523

(71) Applicant: IDEMITSU KOSAN CO., LTD.
Tokyo 100-8321 (JP)

(72) Inventors:
- OKUDA, Fumio
  Chiba, 2990293 (JP)
- WATANABE, Masami
  Chiba, 2990293 (JP)
- IKEDA, Hidetsugu
  Chiba, 2990293 (JP)

(74) Representative: Gille Hrabal Struck Neidlein Prop Roos
Brucknerstrasse 20
40593 Düsseldorf (DE)

# (54) LUMINESCENT METAL COMPLEX, METHOD FOR PRODUCING SAME AND ORGANIC ELECTROLUMINESCENT LIGHT-EMITTING DEVICE USING SAME

(57) A metal complex compound with a structure containing metals such as iridium, and a monodentate ligand such as a hydrogen atom other than a bidentate ligand. An employment of a metal compound with a ligand having two oxygen atoms as a material for preparing the metal complex compound. An organic electroluminescence device being composed of one or more organic thin film layers having at least a light emitting layer sandwiched between a pair of electrodes, wherein at least one of the organic thin film layer contains the metal complex compound. The organic electroluminescence device has an excellent stability, a great efficiency and a long lifetime of light emission due to the metal complex compound.

EP 1 854 803 A1

## Description

TECHNICAL FIELD

The present invention relates to a metal complex compound, a production method for the same and an organic electroluminescence device employing the same. More particularly, the present invention relates to an organic electroluminescence device having an enhanced stability, a high efficiency of light emission and a long lifetime and further, relates to a novel metal complex compound and a production method realizing the device.

BACKGROUND ART

The organic electroluminescence (EL) devices have been expected to be applied to color wide screen image display devices replacing liquid crystal display devices, and have been intensively developed. An organic EL device is a spontaneous light emitting device which utilizes the phenomenon that a fluorescent substance emits light by energy of recombination of holes injected from an anode and electrons injected from a cathode when an electric field is applied. Since an organic EL device of the laminate type driven under a low electric voltage was reported by C. W. Tang et al. of Eastman Kodak Company (C. W. Tang and S. A. Vanslyke, Applied Physics Letters, Volume 51, Page 913, 1987), many studies have been conducted on organic EL devices using organic materials as the constituting materials. Tang et al. used tris(8-quinolinolato)aluminum for the light emitting layer and a triphenyldiamine derivative for the hole transporting layer. Advantages of the laminate structure are that the efficiency of hole injection into the light emitting layer can be increased, that the efficiency of forming excitons which are formed by blocking and recombining electrons injected from the cathode can be increased, and that the excitons formed among the light emitting layer can be confined. As the structure of the organic EL device, a two-layered structure having a hole transporting (injecting) layer and an electron transporting and light emitting layer and a three-layered structure having a hole transporting (injecting) layer, a light emitting layer and an electron transporting (injecting) layer are well known. To increase the efficiency of recombination of injected holes and electrons in the devices of the laminate type, the structure of the device and the process for forming the device have been studied.
As the light emitting material of the organic EL device, chelate complexes such as tris(8-quinolinolato) aluminum, coumarin derivatives, tetraphenylbutadiene derivatives, distyrylarylene derivatives and oxadiazole derivatives are known. It is reported that light in the visible region ranging from blue light to red light can be obtained by using these light emitting materials, and development of a device exhibiting color images is expected (for example, Patent Document 1, Patent Document 2 and Patent Document 3).
However, to realize large screen organic EL devices is still in the course of development because they lack in sufficient light emitting property. In order for improving the light emitting property of the organic EL device, very high-efficiency green light-emitting devices employing ortho-metallated iridium complex (fac-tris(2-phenylpyridine)iridium) as a light emitting material are proposed (for example, Non-Patent Document 1 and Non-Patent Document 2). These technologies utilize phosphorescent material other than a fluorescent material in a light emitting layer of the organic EL device. As described above, a great efficiency of light emission is achieved by utilizing an organic phosphorescent material excited to the singlet state and the triplet state in the light emitting layer of an organic EL device. It is considered that singlet excitons and triplet excitons are formed in relative amounts of 1:3 due to the difference in the multiplicity of spin when electrons and holes are recombined in an organic EL device. Therefore, it is expected that an efficiency of light emission 3 to 4 times as great as that of a device utilizing fluorescence alone can be achieved by utilizing a material emitting phosphorescent light. In other words, the device achieves 8 % of external quantum yield by utilizing the phosphorescent light emission phenomena and surpasses 5 % of external quantum yield informed as the upper limit in the conventional fluorescent device.
In the organic EL devices described above, a construction formed by successively laminating layers such as an anode, a hole transporting layer, an organic light emitting layer, an electron transporting layer (a hole barrier layer), an electron transporting layer and a cathode is used so that the excited state of the triplet or excitons of the triplet do not disappear, and a host compound and a phosphorescent compound are used for the organic light emitting layer (for example, Patent Document 4 and Patent Document 5). In these Patent Documents, technology on phosphorescent materials emitting red to green light is disclosed. Technology on light emitting materials emitting bluish light is also disclosed (for example, Patent Document 6, Patent Document 7 and Patent Document 8). However, devices in accordance with the above technology have very short lives. In particular, in Patent Document 7 and Patent Document 8, skeleton structures of ligands in which Ir metal and phosphorus atom are bonded are described. The bonding in these structures is weak, and heat resistance is markedly poor although the emitted light is bluish. In Patent Document 9, a complex in which an oxygen atom and a nitrogen atom are bonded to a central metal atom is described. However, specific effects of the group bonded to the oxygen atom are obscure because of no disclosure. In Patent Document 10, a complex in which nitrogen atoms contained in different cyclic structures are each bonded to a central metal atom is disclosed. A device

prepared by using the complex exhibits external quantum efficiency as small as 5% although bluish light is emitted. Furthermore, Patent Document 11 discloses a complex wherein substituents $CF_3$ and F are introduced onto a carbon atom adjacent to a carbon atom forming a metal-carbon bond of phenylpyridine ligand as a metal example of Ir complex. However, nothing is disclosed about a specific effect of the position for changing the light emission toward blue.

Because an organic EL device that utilizes phosphorescent light emission is currently limited to green light emission, applied range as color display device is narrow. Development of the device whose luminescent property is improved about other colors is eagerly desired. Regarding particularly with EL devices that emit blue light, those having an external quantum yield exceeding 5 % is not reported yet. Accordingly, an improvement in the EL devices that emit blue light, if possible, enables the display devices to display full colors or white light resultantly advancing toward practical use of phosphorescent light EL device greatly.

Currently, developments about a compound having Ir atom as a phosphorescent luminescent complex are actively carried out, and Compound A below is known as a material employable for an EL device that emits green light. On the other hand, Compounds B and C below are known as materials for an EL device which emits blue light, however, the EL device employing Compounds B and C are not practical in view points of both lifetime and efficiency of the device. Accordingly, it is necessary to develop another complex for EL devices that emit blue light, however, any blue-shift factor except current Compounds B and C has not been found yet now.

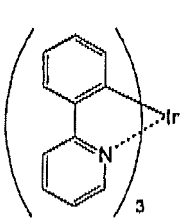
Compound A

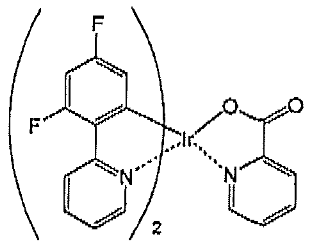
Compound B

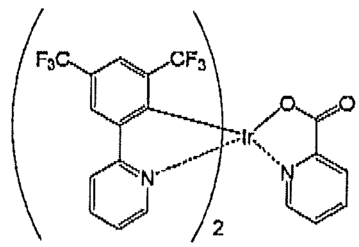
Compound C

All the compounds above are complex group employing bidentate chelate ligand, however, following complexes of the type wherein one phenylpyridine part of Compound A or a picolinic acid ligand part of Compound B or C is replaced to a different monodentate ligand respectively are disclosed. Because these complexes have monodentate ligands, stability of the compound in themselves are poor and characteristics of the luminescent device have been also estimated to be insufficient (for example, Non-Patent Document 3, Non-Patent Document 4, and Patent Document 12).

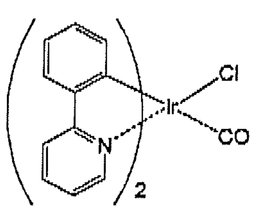

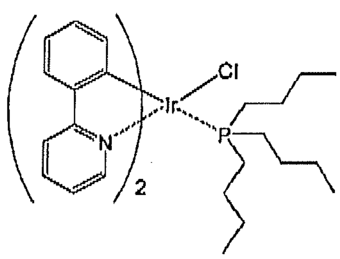

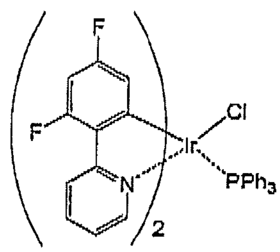

Patent Document 1: Japanese Patent Application Laid-Open No. Heisei 8(1096)-239655
Patent Document 2: Japanese Patent Application Laid-Open No. Heisei 7(1995)-183561
Patent Document 3: Japanese Patent Application Laid-Open No. Heisei 3(1991)-200289
Patent Document 4: United States Patent No. 6,097,147
Patent Document 5: International Patent Publication No. WO 01/41512
Patent Document 6: United States Patent Application Laid-Open No. 2001/0025108
Patent Document 7:United States Patent Application Laid-Open No. 2002/0182441
Patent Document 8: Japanese Patent Application Laid-Open No. 2002-170684
Patent Document 9: Japanese Patent Application Laid-Open No. 2003-123982
Patent Document 10: Japanese Patent Application Laid-Open No. 2003-133074

Patent Document 11: United States Patent No. 2003/0040627
Patent Document 12: International Patent No. WO 02/15645
Non-Patent Document 1: D. F. OBrien, M. A. Baldo et al., "Improved energy transfer in electrophosphorescent devices", Applied Physics letters, Vol.74, No. 3, pp.442-444, January18, 1999.
Non-Patent Document 2: M. A. Baldoetal., "Very high-efficiency green organic light-emitting devices based on electrophosphorescence", Applied Physics letters, Vol.75, No. 1, pp.4 - 6, July5, 1999.
Non-Patent Document 3: C- L. Lee, R. R. Das and J-J. Kim, Chem. Mater., 16 (23), 4642 (2004).
Non-Patent Document 4: W. J. Finkenzeller, P. Stossel, and H. Yersin, Chem. Physics Lett., 289 (2004).

DISCLOSURE OF THE INVENTION

[Problems to be overcome by the Invention]

The present invention has been made to overcome the above problems and has an object of providing an organic EL device with enhanced stability, with enhanced efficiency of light emission and having long lifetime, to provide a novel metal complex compound realizing the device, and to provide a production method of the compound.

[Means for overcoming the Problems]

As a result of intensive researches and studies to achieve the above object by the present inventors, it was found that a replacement of Cl part in a well-known monodentate ligand with a different monodentate ligand such as H, CO or so exhibits unexpected sublimation stability and provides an organic EL device having an enhanced efficiency of light emission and prolonged lifetime. Further, it was found that there is also an effect of shortening a wavelength of light emission shorter than conventional complex. As a result, it was found that an employment of a metal complex compound represented by following general formula (1) provides an organic EL device having an enhanced efficiency of light emission and prolonged lifetime. Furthermore, it was found that an employment of a metal compound with a ligand having two oxygen atoms as a material enables to effectively prepare the metal complex compound represented by following general formula (1). The present invention has been accomplished based on the above knowledge and findings.

The present invention provides a metal complex compound described in any one of following (a) to (e), an organic electroluminescence device employing the same described in any one of following (f) to (k) and a production method for the metal complex compound described in any one of following (1) and (m). Namely, the present invention provides:

(a) A metal complex compound represented by following general formula (1):

$$(L_1)_mM(L_2)_n(L_3)_k \qquad (1)$$

[In general formula (1), M represents a metal atom of iridium (Ir), platinum (Pt) or rhodium (Rh); $L_1$ represents a bidentate ligand, $L_2$ and $L_3$ represent monodentate ligands different from each other and being not bonded mutually; m, n and k each represents an integer of 1 or 2, and m+n+k represents an integer of 3 to 5; the partial structure represented by $(L_1)_mM$ is represented by following general formula (2):

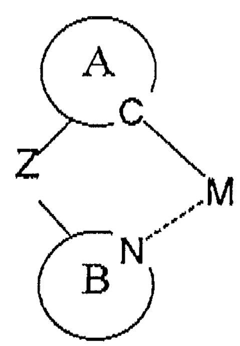

(2)

{In general formula (2), N represents a nitrogen atom, C represents a carbon atom, ring A represents an aryl group having 6 to 50 ring carbon atoms which may have substituents, ring B represents an aromatic heterocyclic group having 3 to 50 ring atoms including a nitrogen atom which may have substituents, ring A and ring B are bonded with covalent

bonds via Z; Z represents a single bond, -O-, -S-, -CO-, - (CR'R")a-, - $(SiR'R")_a$- or -NR'-; (R' and R" each independently represents a hydrogen atom, an aryl group having 6 to 50 ring carbon atoms which may have substituents, an aromatic heterocyclic group having 3 to 50 ring atoms which may have substituents, or an alkyl group having 1 to 30 carbon atoms which may have substituents; a represents an integer of 1 to 10; and the atoms and the groups represented by R' and R" may be the same with or different from each other.)}

$L_2$ is a monovalent group which forms a covalent bond with M, and represents a hydrogen atom, an alkyl group having 1 to 30 carbon atoms which may have substituents, an aryl group having 6 to 50 ring carbon atoms which may have substituents, or a silyl group with an alkyl group having 1 to 30 carbon atoms which may have substituents; and $L_3$ represents a group forming a coordinate bond with M.];

(b) A metal complex compound described in (a), wherein the partial structure represented by $(L_1)_mM$ is a partial structure represented by any one of following general formulae:

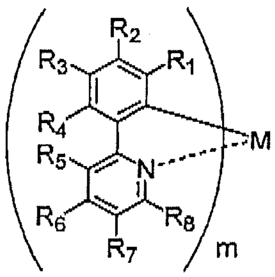

(3)

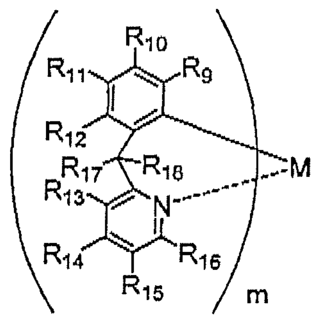

(4)

(In the above formulae, M and m are same as described above; $R_1$ to $R_{18}$ each independently represents a hydrogen atom, an alkyl group having 1 to 30 carbon atoms which may have substituents, a halogenated alkyl group having 1 to 30 carbon atoms which may have substituents, an alkoxyl group having 1 to 30 carbon atoms which may have substituents, a heterocyclic group having 3 to 50 ring atoms which may have substituents, an aryl group having 6 to 50 ring carbon atoms which may have substituents, an aryloxyl group having 6 to 40 ring carbon atoms which may have substituents, an aralkyl group having 7 to 40 carbon atoms which may have substituents, an alkenyl group having 2 to 30 carbon atoms which may have substituents, an arylamino group having 6 to 80 ring carbon atoms which may have substituents, an alkylamino group having 1 to 60 carbon atoms which may have substituents, an aralkylamino group having 7 to 80 carbon atoms which may have substituents, a silyl group with alkyl group having 1 to 30 carbon atoms which may have substituents, an arylsilyl group having 6 to 40 carbon atoms which may have substituents, a halogen atom, a cyano group, a nitro group, $-S(R)O_2$ or -S(R)O wherein R represents a substituent, and adjacent groups represented by $R_1$ to $R_8$ and $R_9$ to $R_{16}$ may be bonded each other to form a cyclic structure.);

(c) A metal complex compound described in any one of (a) or (b), wherein the partial structure represented by $(M(L_2)_n(L_3)_k$ is a partial structure represented by any one of following general formulae:

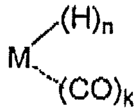

(5)

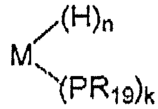

(6)

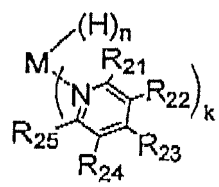

(7)

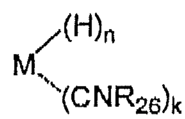

(8)

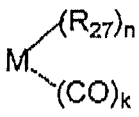
(9)

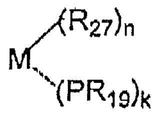
(10)

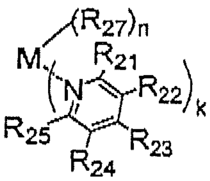
(11)

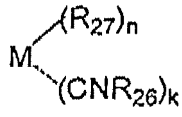
(12)

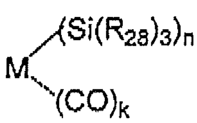
(13)

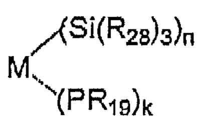
(14)

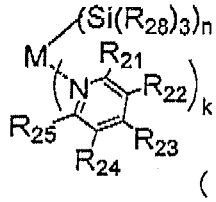
(15)

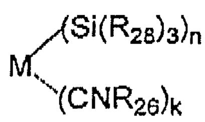
(16)

(In the above formulae, M, n and k are same as described above; $R_{19}$ to $R_{26}$ and $R_{28}$ each independently represents a hydrogen atom, an alkyl group having 1 to 30 carbon atoms which may have substituents, a halogenated alkyl group having 1 to 30 carbon atoms which may have substituents, an alkoxyl group having 1 to 30 carbon atoms which may have substituents, a heterocyclic group having 3 to 50 ring atoms which may have substituents, an aryl group having 6 to 50 ring carbon atoms which may have substituents, an aryloxyl group having 6 to 40 ring carbon atoms which may have substituents, an aralkyl group having 7 to 40 carbon atoms which may have substituents, an alkenyl group having 2 to 30 carbon atoms which may have substituents, an arylamino group having 6 to 80 ring carbon atoms which may have substituents, an alkylamino group having 1 to 60 carbon atoms which may have substituents, an aralkylamino group having 7 to 80 carbon atoms which may have substituents, a silyl group with alkyl group having 1 to 30 carbon atoms which may have substituents, an arylsilyl group having 6 to 40 carbon atoms which may have substituents, a halogen atom, a cyano group, or a nitro group, and adjacent groups represented by $R_{21}$ to $R_{20}$ may be bonded each other to form a cyclic structure; further, $R_{27}$ represents an alkyl group having 1 to 30 carbon atoms which may have substituents, a halogenated alkyl group having 1 to 30 carbon atoms which may have substituents, a heterocycle group having 3 to 20 ring atoms which may have substituents, an aryl group having 6 to 50 ring carbon atoms which may have substituents, an aralkyl group having 7 to 40 carbon atoms which may have substituents, or an alkenyl group having 2 to 30 carbon atoms which may have substituents.);

(d) A metal complex compound described in (c), wherein the partial structure represented by $(L_1)_mM$ which is represented by the above general formula (2) is a partial structure represented by any one of the above general formula (3) or (4) and further, wherein the partial structure represented by $M(L_2)_n(L_3)_k$ is a partial structure represented by any one of the above general formulae (5) to (16);

(e) A metal complex compound described in (c), wherein the partial structure represented by $(L_1)_mM$ which is represented by the above general formula (2) is a partial structure represented by any one of the above general formula (3) or (4), wherein the partial structure represented by $M(L_2)_n(L_3)_k$ is a partial structure represented by any one of the above general formulae (5) to (16), wherein m is an integer of 2, n and k are each an integer of 1, and M is an iridium atom;

(f) An organic electroluminescence device which is composed of one or more organic thin film layers including at least one light emitting layer sandwiched between an anode and a cathode, wherein at least one of the organic thin film layers contains the metal complex compound described in any one of (a) to (e);

(g) An organic electroluminescence device described in (f), wherein the light emitting layer contains the metal complex compound described in any one of (a) to (e);

(h) An organic electroluminescence device described in (f), wherein the light emitting layer contains the metal complex compound described in any one of (a) to (e) as a dopant;

(i) An organic electroluminescence device described in (f), wherein an electron injecting layer and/or an electron transporting layer is sandwiched between the light emitting layer and the cathode, and wherein the electron injecting layer and/or the electron transporting layer contains a $\pi$-electron-deficient heterocyclic derivative having a nitrogen atom as a main component.

(j) An organic electroluminescence device described in (f), wherein a reducing dopant is added in an interfacial region

of the cathode and the organic thin film layer.

(k) An organic electroluminescence device described in (f), wherein the layer containing the metal complex compound described in any one of (a) to (e) between the anode and the cathode is formed as a thin film layer in accordance with a coating process.

(1) A production method for preparing the metal complex compound described in any one of (a) to (e), wherein a metal complex compound represented by any one of following general formulae (C) or (D) is employed as a material metal compound.

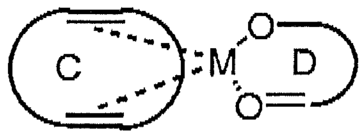

(C)

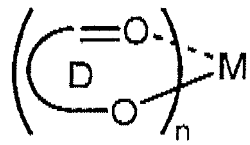

(D)

(In the general formulae (C) and (D), M represents a metal atom of indium (Ir), platinum (Pt) or rhodium (Rh) and n represents an integer of 2 or 3;

ring C represents a cyclic diolefin compound having 8 to 20 carbon atoms, and a part except M constituting ring D is a compound containing two oxygen atoms and having 5 to 23 carbon atoms.); and

(m) A production method for preparing the metal complex compound described in (1), wherein the material metal compound is represented by any one of following general formulae:

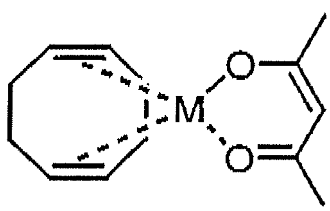

(COD)M(acac)

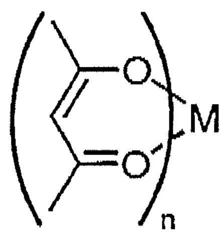

$M(acac)_n$

(In the above formulae, M and n are same as described above).

[The Effect of the Invention]

In accordance with the present invention, an employment of the metal complex compound represented by the following general formula (1) wherein a replacement of Cl part in a well-known monodentate ligand with a different monodentate ligand such as H, CO or so has been successful in achieving an organic EL device with an enhanced efficiency of light emission and with a prolonged lifetime. Further, it has been also successful to effectively prepare the metal complex compound represented by the following general formula (1) in accordance with an employment of a metal compound with a ligand having two oxygen atoms as a material.

PREFERRED EMBODIMENT TO CARRY OUT THE INVENTION

The present invention provides a metal complex compound represented by following general formula (1):

$$(L_1)_mM(L_2)_n(L_3)_k \qquad (1)$$

[In general formula (1), M represents a metal atom of iridium (Ir), platinum (Pt) or rhodium (Rh); $L_1$ represents a bidentate ligand, $L_2$ and $L_3$ represent monodentate ligands different from each other and being not bonded mutually; m, n and k each represents an integer of 1 or 2, and m+n+k represents an integer of 3 to 5; $L_2$ is a monovalent group which forms a covalent bond with M, and represents a hydrogen atom, an alkyl group having 1 to 30 carbon atoms which may have substituents, an aryl group having 6 to 50 ring carbon atoms which may have substituents, or a silyl group

with an alkyl group having 1 to 30 carbon atoms which may have substituents; La represents a group forming a coordinate bond with M.]

The partial structure represented by $(L_1)_mM$ in the general formula (1) has a structure shown by the general formulae (2) to (4) as described in detail in the above (a) and (b), and further, the partial structure represented by $M(L_2)_n(L_3)_k$ in the general formula (1) has a structure shown by the general formulae (5) to (16) as described in detail in the above (c). Further, the partial structure represented by $(L_1)_mM$ has the structure shown by the general formulae (2) to (4) and the partial structure represented by $M(L_2)_n(L_3)_k$ has the structure shown by the general formulae (5) to (16). Furthermore, the present invention also includes a special embodiment of the metal complex compound wherein m, n and k in the general formula (1) are each integer of 2, 1 and 1 respectively and wherein M in the general formula (1) corresponds to an iridium atom.

Still further, the present invention provides an organic electroluminescence device which is composed of one or more organic thin film layers including at least one light emitting layer sandwiched between an anode and a cathode, wherein at least one of the organic thin film layers contain the metal complex compound represented by the above general formula (1).

The light emitting layer in the organic electroluminescence device of the present invention contains the metal complex compound represented by the general formula (1) as a light emitting material and/or a dopant. In the organic electroluminescence device of the present invention, an electron injecting layer and/or an electron transporting layer is sandwiched between the light emitting layer and the cathode, and the electron injecting layer and/or the electron transporting layer contains a $\pi$ -electron-deficient heterocyclic derivative having a nitrogen atom as a main component. In the organic electroluminescence device of the present invention, a reducing dopant is added in the interfacial region of the cathode and the organic thin film layer. In the organic electroluminescence device of the present invention, the layer comprising the metal complex compound of the present invention is formed as a thin film layer in accordance with a coating process. In the production method for preparing the metal complex compound of the present invention, a metal complex compound represented by any one of above-mentioned general formula (C) or (D) is employed as a material metal compound as described in the above (l) and (m). Moreover, examples of the material metal complex include general formulae (COD) M (acac) or $M(acac)_n$.

To begin with, specific examples of groups constituting the foregoing $L_1$, $L_2$ and $L_3$ in the present invention will be explained below.

The aryl group of the above ring A is the aryl group having 6 to 50 ring carbon atoms which may have substituents and further, it is preferable to have 6 to 24 ring carbon atoms; examples include phenyl group, 1-naphthyl group, 2-naphthyl group, 1-anthryl group, 2-anthryl group, 9-anthryl group, 1-phenanthryl group, 2-phenanthryl group, 3-phenanthryl group, 4-phenanthryl group, 9-phenanthryl group, 1-naphthacenyl group, 2-naphthacenyl group, 9-naphthacenyl group, 1-pyrenyl group, 2-pyrenyl group, 4-pyrenyl group, 2-biphenylyl group, 3-biphenylyl group, 4-biphenylyl group, p-terphenyl-4-yl group, p-terphenyl-3-yl group, p-terphenyl-2-yl group, m-terphenyl-4-yl group, m-terphenyl-3-yl group, m-terphenyl-2-yl group, o-tolyl group, m-tolyl group, p-tolyl group, p-t-butylphenyl group, p-(2-phenylpropyl)phenyl group, 3-methyl-2-naphthyl group, 4-methyl-1-naphthyl group, 4-methyl-1-anthryl group, 4'-methylbiphenyl-yl group, 4"-t-butyl-p-terphenyl-4-yl group, o-cumenyl group, m-cumenyl group, p-cumenyl group, 2,3-xylyl group, 3,4-xylyl group, 2,5-xylyl group, mesityl group, perfluorophenyl group, 2,4-difluorophenyl group, 3,5-bis(trifluoromethyl)phenyl group, 3,5-dicyanophenyl group, etc.

Among those aryl groups, phenyl group, 1-naphthyl group, 2-naphthyl group, 9-phenanthryl group, 2-biphenyl group, 3-biphenylyl group, 4-biphenylyl group, p-tolyl group, 3,4-xylyl group, 2,4-difluorophenyl group, 3,5-bis(trifluoromethyl) phenyl group and 3,5-dicyanophenyl group are preferable.

As the aromatic heterocyclic group having a nitrogen atom represented by the above ring B, groups having 3 to 50 ring atoms are preferable, and groups having 3 to 10 ring atoms are more preferable. Examples of the aromatic heterocyclic group having a nitrogen atom include pyrazinyl group, pyridyl group, pyrimidinyl group, pyrazolyl group, imidazolyl group, indolizinyl group, imidazopyridinyl group, quinolyl group, isoquinolyl group, quinoxalinyl group, etc.

Among those groups, pyrazinyl group, pyridyl group, pyrimidinyl group, pyrazolyl group, imidazolyl group, quinolyl group and isoquinolyl group are preferable.

With regard to the alkyl group having 1 to 30 carbon atoms which may have substituents, it is preferable to have 1 to 10 carbon atoms; examples of the alkyl group include methyl group, ethyl group, propyl group, isopropyl group, n-butyl group, s-butyl group, isobutyl group, t-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neopentyl group, 1-methylpentyl group, 2-methylpentyl group, 1-pentylhexyl group, 1-butylpentyl group, 1-heptyloctyl group, 3-methylpentyl group, hydroxymethyl group, 1-hydroxyethyl group, 2-hydroxyethyl group, 2-hydroxyisabutyl group, 1,2-dihydroxyethyl group, 1,3-dihydroxyisopropyl group, 2,3-dihydroxy-t-butyl group, 1,2,3-trihydroxypropyl group, aminomethyl group, 1-aminoethyl group, 2-aminoethyl group, 2-aminoisobutyl group, 1,2-diaminoethyl group, 1,3-diaminoisopropyl group, 2,3-diamino-t-butyl group, 1,2,3-triaminopropyl group, cyanomethyl group, 1-cyanoethyl group, 2-cyanoethyl group, 2-cyanoisobutyl group, 1,2-dicyanoethyl group, 1,3-dicyanoisopropyl group, 2,3-dicyano-t-butyl group, 1,2,3-tricyanopropyl group, nitromethyl group, 1-nitroethyl group, 2-nitroethyl group, 1,2-dinitroethyl group, 2,3-dinitro-t-butyl group, 1,2,3-trinitropropyl group, cyclopentyl group, cyclohexyl group, cyclo octyl group, 3,5-dimethylcyclohexyl group, 3,3,5,5-tetramethylcyclohexyl group, etc.
Among those groups, methyl group, ethyl group, propyl group, isopropyl group, n-butyl group, s-butyl group, isobutyl group, t-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neopentyl group, 1-methylpentyl group, 1-pentylhexyl group, 1-butylpentyl group, 1-heptyloctyl group, cyclohexyl group, cyclooctyl group, 3,5-dimethylcyclohexyl group and 3,3,5,5-tetramethylcyclohexyl group are preferable.

As the hologenated alkyl group having 1 to 30 carbon atoms which may have substituents, it is preferable to have 1 to 10 carbon atoms; examples include chloromethyl group, 1-chloroethyl group, 2-chloroethyl group, 2-chloroisobutyl group, 1,2-dichlaroethyl group, 1,3-dichloroisopropyl group, 2,3-dichloro-t-butyl group, 1,2,3-trichloropropyl group, bromomethyl group, 1-bromoethyl group, 2-bromoethyl group, 2-bromoisobutyl group, 1,2-dibromoethyl group, 1,3-dibromoisopropyl group, 2,3-dibramo-t-butyl group, 1,2,3-tribromopropyl group, iodomethyl group, 1-iocloethyl group, 2-iodoethyl group, 2-iodoisobutyl group, 1,2-diiodoethyl group, 1,3-diiodoisopropyl group, 2,3-diioda-t-butyl group, 1,2,3-triiodopropyl group, fluoromethyl group, 1-fluoroethyl group, 2-fluoroethyl group, 2-fluoroisobutyl group, 1,2-difluoroethyl group, difluoromethyl group, trifluoromethyl group, pentafluoroethyl group, perfluoroisopropyl group, perfluorobutyl group, perfluorocyclohexyl group, etc.
Among those halogenated alkyl groups, fluoromethyl group, trifluoromethyl group, pentafluoroethyl group, perfluoroisopropyl group, perfluorobutyl group and perfluorocyclohexyl group are more preferable.

The alkoxyl group having 1 to 30 carbon atoms which may have substituents is a group represented by $-OX_1$. Examples of the group represented by $X_1$ preferably have 1 to 10 carbon atoms and include the groups described above as the examples of the alkyl group and the halogenated alkyl group.
The aryloxyl group having 6 to 40 ring atoms which may have substituents is represented by -OAr. Examples of the group represented by Ar include the groups described above as examples of the aryl group.

As the aralkyl group having 7 to 40 carbon atoms which may have substituents, it is preferable to have 7 to 18 carbon atoms; examples include benzyl group, 1-phenylethyl group, 2-phenylethyl group, 1-phenylisopropyl group, 2-phenylisopropyl group, phonyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, 7-pyrrolylmethyl group, 2-(1-pyrrolyl) ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydxoxybenzyl group, o-hydxoxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group, 1-chloro-2-phenylisopropyl group, etc. Among those aralkyl groups, benzyl group, p-cyanobenzyl group, m-cyanobenzyl group, o-cyanobenzyl group, 1-phenylethyl group, 2-phenylethyl group, 1-phenylisopropyl group and 2-phenylisopropyl groups are more preferable.

The silyl group with an alkyl group having 1 to 30 carbon atoms which may have substituents is expressed with $-SiE_1E_2E_3$, and it is preferable for examples of $E_1$, $E_2$ and $E_3$ to have each independently 1 to 10 carbon atoms and further, they include the groups described above as examples of the above alkyl group.
The arylsilyl group having 6 to 50 carbon atoms which may have substituents is expressed with $-SiAr_1Ar_2Ar_3$, and examples of $Ar_1$, $Ar_2$ and $Ar_3$ each independently include the groups described above as examples of the above aryl group.
It is preferable for the alkenyl group having 2 to 30 carbon atoms which may have substituents to have 2 to 16 carbon atoms. Examples of the alkenyl group include vinyl group, allyl group, 1-butenyl group, 2-butenyl group, 3-butenyl group, 1,3-butadienyl group, 1-methylvinyl group, styryl group, 2,2-diphenylvinyl group, 1,2-diphenylvinyl group, 1-methylallyl group, 1,1-dimethylallyl group, 2-methylallyl group, 1-phenylallyl group, 2-phenylallyl group, 3-phenylanyl group, 3,3-diphonylallyl group, 1,2-dimethylallyl group, 1-phenyl-1-butenyl group, 3-phenyl-1-butenyl group, etc. Among these alkenyl groups, styryl group, 2,2-diphenylvinyl group and 1,2-diphenylvinyl group are more preferable.

The arylamino group having 6 to 80 ring carbon atoms which may have substituents, the alkylamino group having 1 to 60 carbon atoms which may have substituents and the aralkylamino group having 7 to 80 carbon atoms which may have substituents are expressed with $-NQ_1Q_2$. It is preferable that $Q_1$ and $Q_2$ each independently represent an atom or a group having 1 to 20 carbon atoms. Examples of the atoms and the group having 1 to 20 carbon atoms include hydrogen atom and the groups described above as the examples of the aryl group, the alkyl group and the aralkyl group.

Examples of the cyclic structure which may be formed by bonding of the groups with each other include structures of cycloalkanes having 4 to 12 carbon atoms such as cyclobutane, cyclopentane, cyclohexane, adamantane and norbornane, structures of cycloalkenes having 4 to 12 carbon atoms such as cyclobutene, cyclopentene, cyclohexene, cycloheptene and cyclooctene, structures of cycloalkadienes having 6 to 12 carbon atoms such as cyclohexadiene, cycloheptadiene and cyclooctadiene, aromatic rings having 6 to 50 carbon atoms such as benzene ring, naphthalene ring, phenanthrene ring, anthracene ring, pyrene ring, chrysene ring and acenaphthylene ring, and aromatic rings including a nitrogen atom such as pyridine ring, quinoline ring and isoquinoline ring.

Specific examples of the metal complex compound of the present invention represented by the general formula (1) include the following compounds, though not limited thereto.

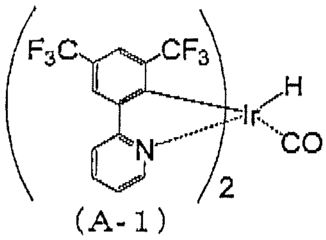

(A-1)

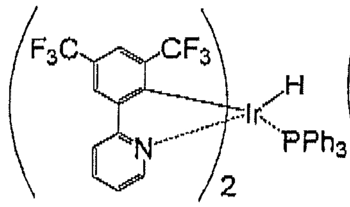

(A-2)

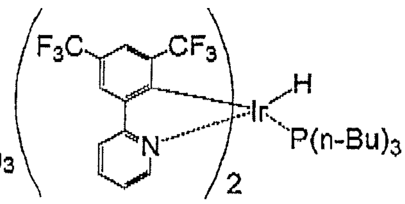

(A-3)

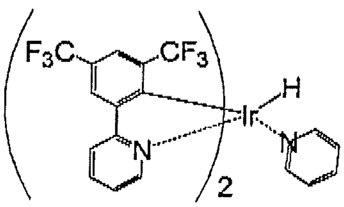

(A-4)

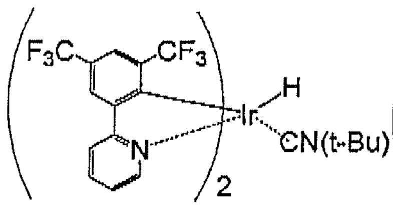

(A-5)

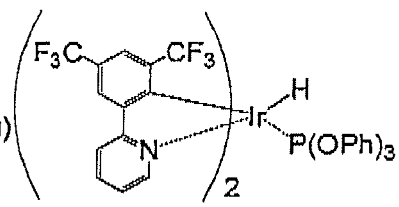

(A-6)

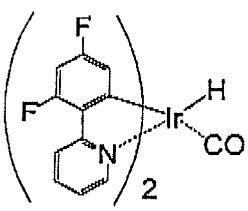

(A-7)

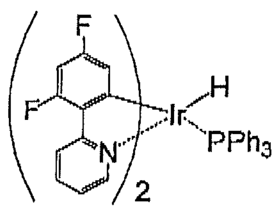

(A-8)

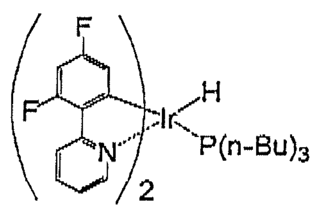

(A-9)

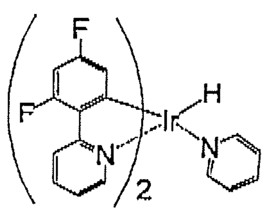

(A-10)

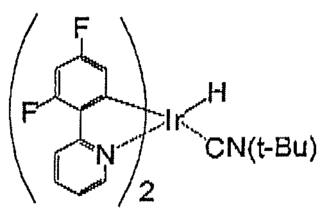

(A-11)

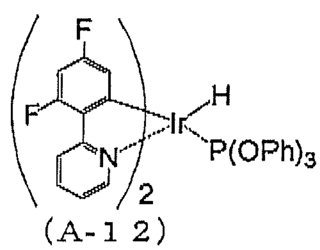

(A-12)

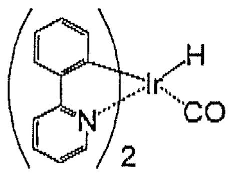

(A-1 3)

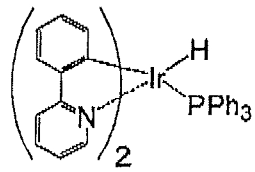

(A-1 4)

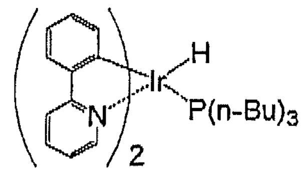

(A-1 5)

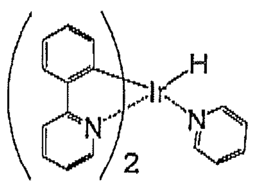

(A-1 6)

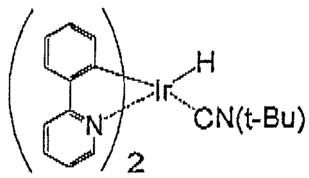

(A-1 7)

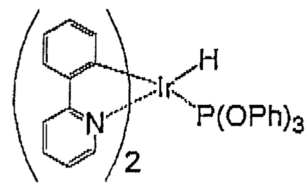

(A-1 8)

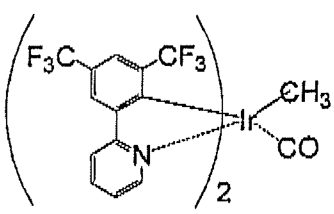

(B-1)

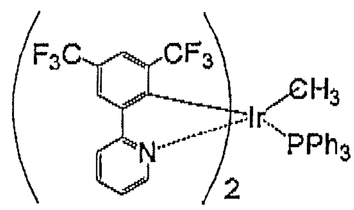

(B-2)

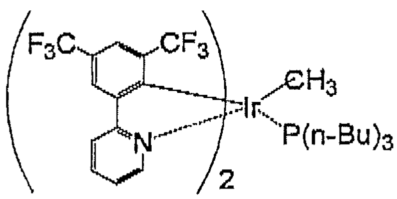

(B-3)

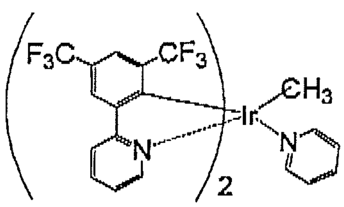

(B-4)

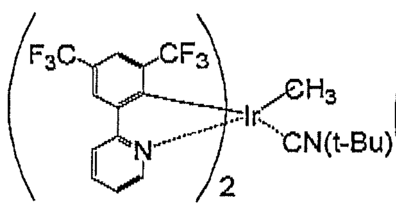

(B-5)

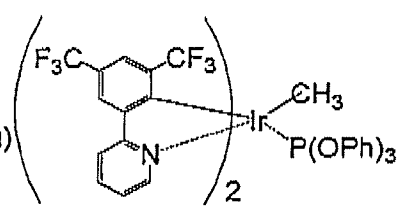

(B-6)

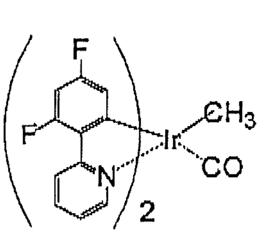

(B-7)

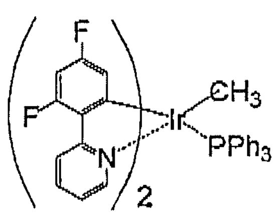

(B-8)

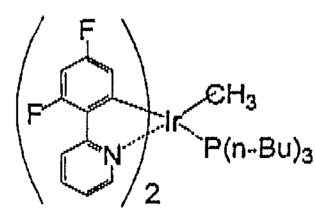

(B-9)

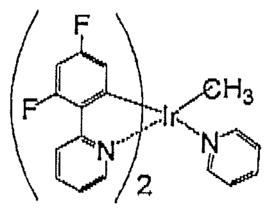
(B-10)

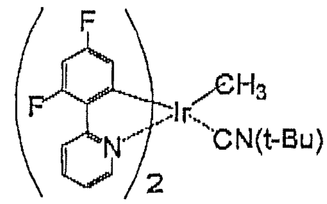
(B-11)

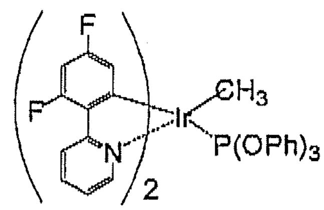
(B-12)

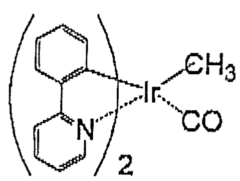
(B-13)

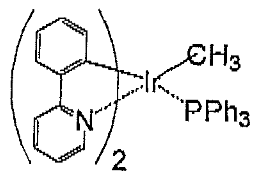
(B-14)

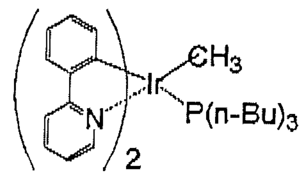
(B-15)

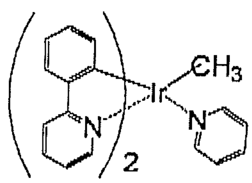
(B-16)

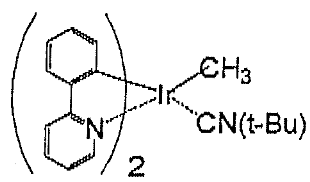
(B-17)

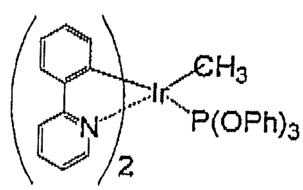
(B-18)

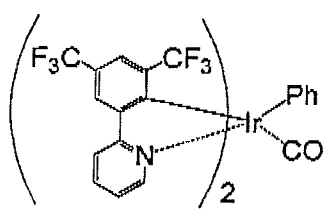
(B-19)

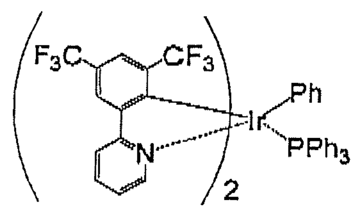
(B-20)

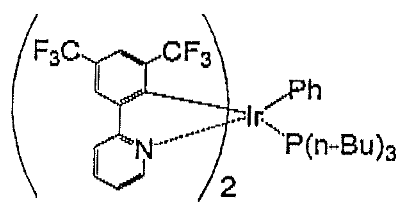
(B-21)

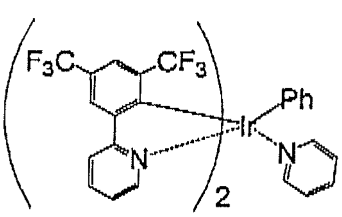
(B-22)

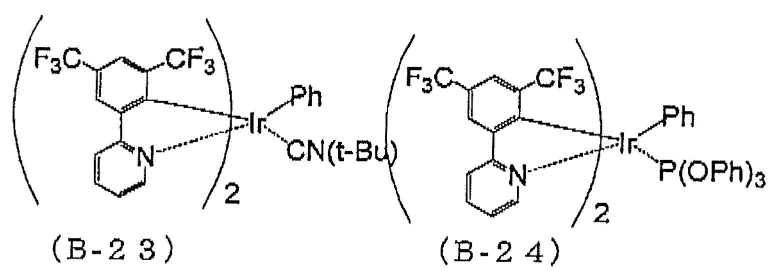
(B-23)

(B-24)

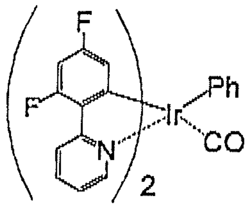

(B-25)

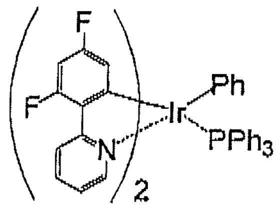

(B-26)

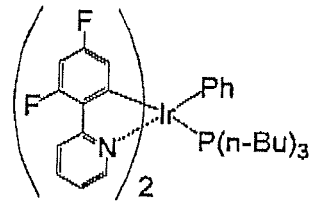

(B-27)

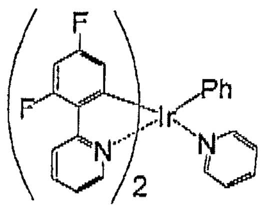

(B-28)

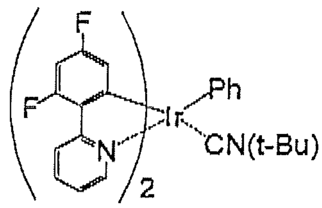

(B-29)

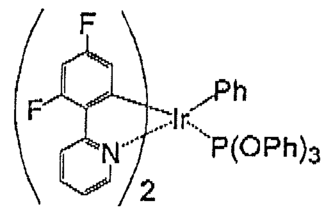

(B-30)

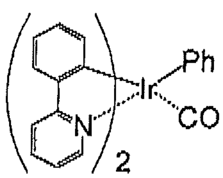

(B-31)

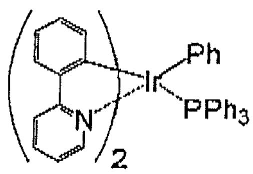

(B-32)

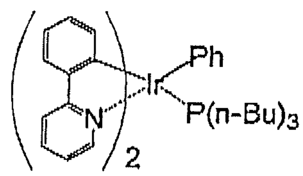

(B-33)

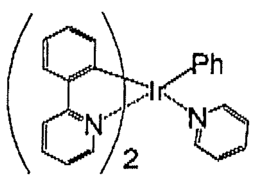

(B-34)

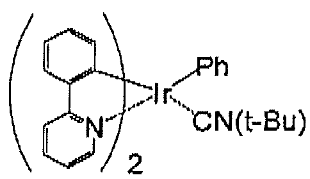

(B-35)

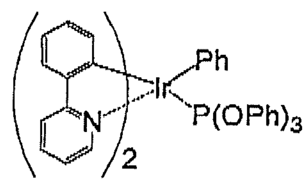

(B-36)

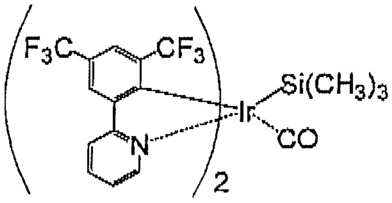

(C-1)

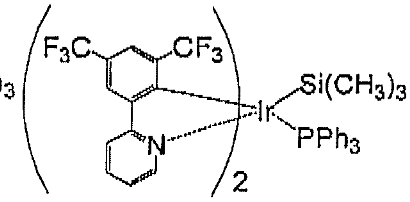

(C-2)

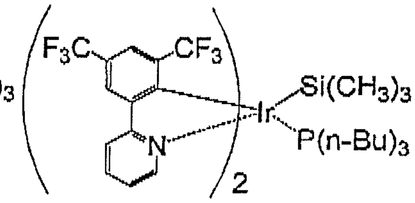

(C-3)

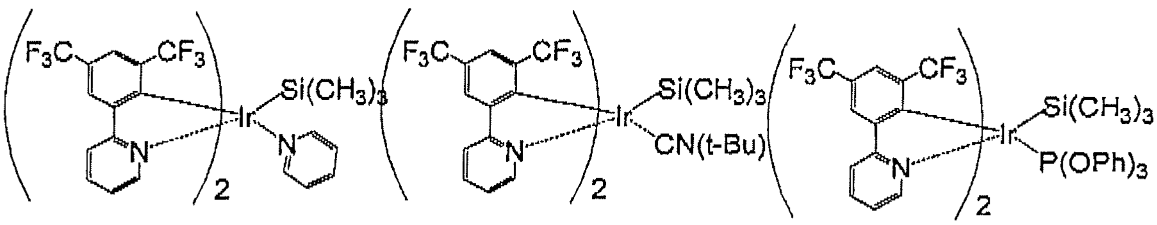

(C-4) (C-5) (C-6)

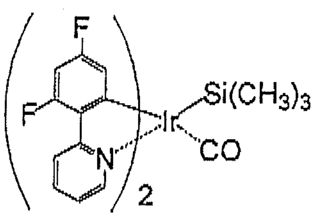

(C-7)

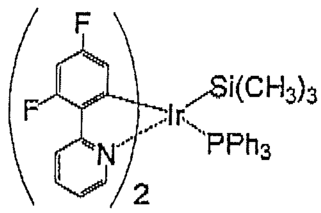

(C-8)

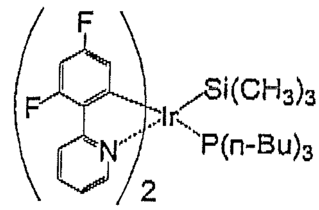

(C-9)

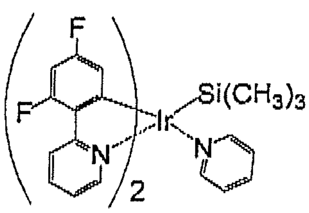

(C-10)

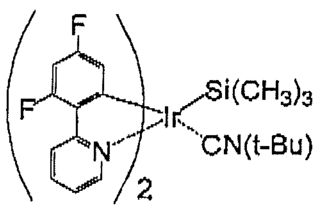

(C-11)

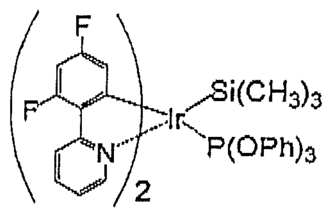

(C-12)

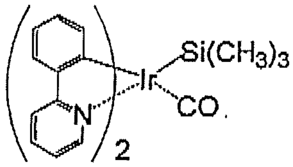

(C-13)

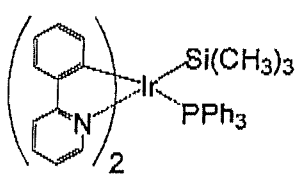

(C-14)

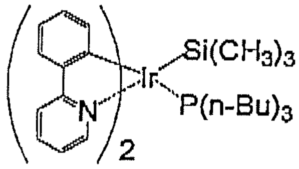

(C-15)

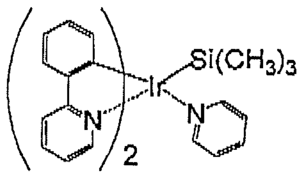

(C-16)

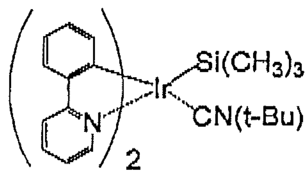

(C-17)

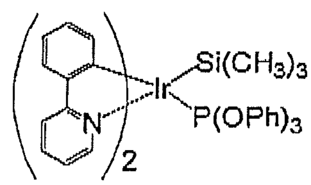

(C-18)

The present invention provides an organic EL device composed of an anode, a cathode and one or more organic thin film layers having at least a light emitting layer sandwiched between the anode and the cathode, wherein at least one of the organic thin film layer contains the metal complex compound of the present invention. With regard to the amount of the metal complex compound of the present invention contained in the organic thin film layer, it is usually 0.1 to 100 % by weight, preferably 1 to 30 % by weight of total weight of the light emitting layer. In the organic EL device of the present invention, it is preferable that the light emitting layer contains a metal complex compound of the present invention as the light emitting material. In general, the light emitting layer is formed as a thin layer in accordance with the vacuum vapor deposition process or the coating process. It is preferable that the layer comprising the metal complex compound of the present invention is formed as a thin film layer in accordance with the coating process since the production process can be simplified by using the coating process.

In the organic EL device of the present invention, when the organic thin film layer is a single layer, the organic thin film layer is the light emitting layer, and the light emitting layer comprises the metal complex compound of the present invention. When the organic thin film layer in the organic EL device comprises a plurality of layers, examples of the construction of the device include: (an anode / a hole injecting layer (a hole transporting layer) / a light emitting layer / a cathode), (an anode / a light emitting layer / an electron injecting layer (an electron transporting layer) / a cathode) and (an anode / a hole injecting layer (a hole transporting layer) / a light emitting layer / an electron injecting layer (an electron transporting layer) /a cathode).

The anode in the organic EL device of the present invention supplies holes to the hole injecting layer, the hole transporting layer and the light emitting layer, and it is effective that the anode has a work function of 4.5 eV or greater. As the material for the anode, metals, alloys, metal oxides, electrically conductive compounds and mixtures of these substances can be used. Examples of the material for the anode include electrically conductive metal oxides such as tin oxide, zinc oxide, indium oxide and indium tin oxide (ITO), metals such as gold, silver, chromium and nickel, mixtures and laminates of these electrically conductive metal oxides and metals, electrically conductive inorganic substances such as copper iodide and copper sulfide, electrically conductive organic substances such as polyaniline, polythiophene and polypyrrol and laminates of these substances with ITO. Electrically conductive metal oxides are preferable, and ITO is more preferable from the standpoint of productivity, great electric conductivity and transparency. The thickness of the anode can be suitably selected in accordance with the material.

The cathode in the organic EL device of the present invention supplies electrons into the electron injecting layer, the electron transporting layer and the light emitting layer. As the material for the cathode, metals, alloys, metal halides, metal oxides, electrically conductive compounds and mixtures of these substances can be used. Examples of the material for the cathode include alkali metals (for example, Li, Na, K and the like), fluorides and oxides of alkali metals, alkaline earth metals (for example, Mg, Ca and the like), fluorides and oxides of alkaline earth metals, gold, silver, lead, aluminum, sodium-potassium alloys, sodium-potassium mixed metals, lithium-aluminum alloys, lithium-aluminum mixed metals, magnesium-silver alloys, magnesium-silver mixed metals and rare earth metals such as indium and ytterbium. Among these materials, aluminum, lithium-aluminum alloys, lithium-aluminum mixed metals, magnesium-silver alloys and magnesium-silver mixed metals are preferable. The cathode may have a single layer structure comprising the above material or a laminate structure having a layer comprising the above material. For example, laminate structures having structures of aluminum/lithium fluoride and aluminum/lithium oxide are preferable. The thickness of the cathode can be suitably selected in accordance with the material.

As for the hole injecting layer and the hole transporting layer in the organic EL device of the present invention, it is sufficient that the layer has any of the function of injecting holes from the anode, the function of transporting holes and the function of forming a barrier to electrons injected from the cathode. Examples of the material for the hole injecting layer and the hole transporting layer include carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, chalcone derivatives substituted with amino group, styrylanthracene derivatives, fluorenone derivatives, hydrazone derivatives, stilbene derivatives, silazane derivatives, aromatic tertiary amine compounds, styrylamine compounds, aromatic dimethylidine-based compounds, porphyrin-based compounds, polysilane-based compounds, poly(N-vinylcarbazole) derivatives, aniline-based copolymers, electrically conductive macromolecular oligomers such as thiophene oligomers and polythiophenes, organic silane derivatives and metal complex compounds of the present invention. The hole injecting layer and the hole transporting layer described above may have a structure having a single layer consisting of one or more kinds of material selected from the above materials or a multi-layer structure having a plurality of layers containing the same composition or different compositions.

As for the electron injecting layer and the electron transporting layer in the organic EL device of the present invention, it is sufficient that the layer has any of the function of injecting electrons from the cathode, the function of transporting electrons and the function of forming a barrier to holes injected from the anode. Examples of the material for the electron injecting layer and the electron transporting layer include triazole derivatives, oxazole derivatives, oxadiazole derivatives, imidazole derivatives, fluorenone derivatives, anthraquinodimethane derivatives, anthrone derivatives, diphenylquinone derivatives, thiopyrandioxide derivatives, carbodiimide derivatives, fluorenylidenemethane derivatives, distyrylpyrazine derivatives, tetracarboxylic acid anhydrides having an aromatic ring such as naphthalene ring and perylene ring, phthalocyanine derivatives, various metal complexes such as metal complexes of 8-quinolinol derivatives, metal complexes having phthalocyanine, benzoxazole or benzothiazole as the ligand, organic silane derivatives and the metal complex compounds of the present invention. The electron injecting layer and the electron transporting layer described above may have a structure having a single layer consisting of one or more kind of material selected from the above materials or a multi-layer structure having a plurality of layers containing the same composition or different compositions.

Further, following compounds are electron transporting materials employable for the electron injecting layer and the electron transporting layer.

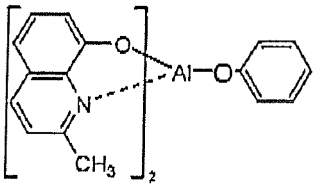
(D-1)

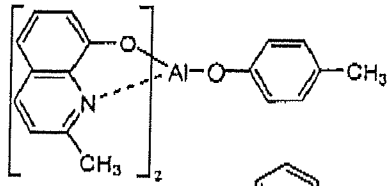
(D-2)

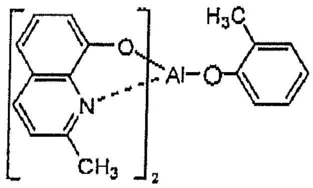
(D-3)

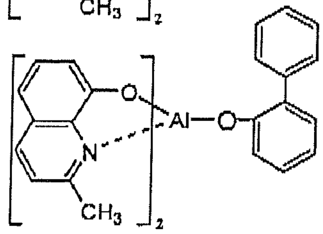
(D-4)

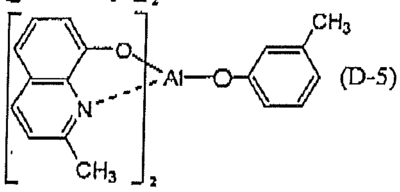
(D-5)

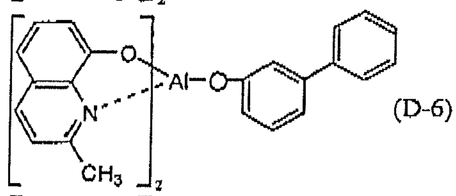
(D-6)

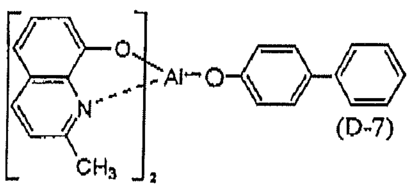
(D-7)

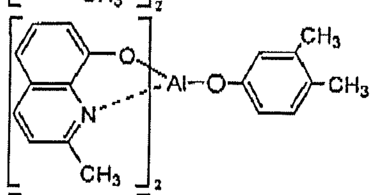
(D-8)

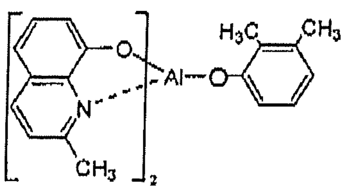
(D-9)

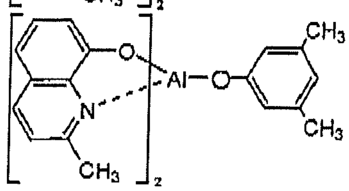
(D-10)

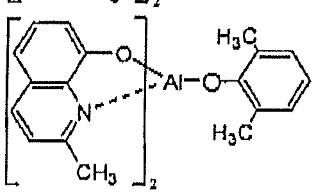
(D-11)

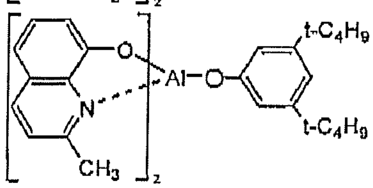
(D-12)

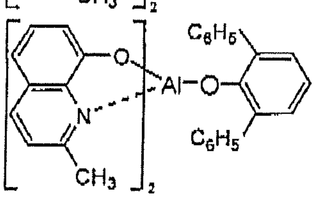
(D-13)

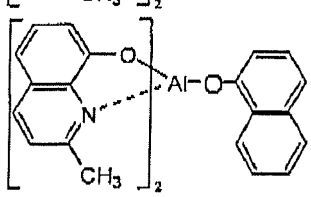
(D-14)

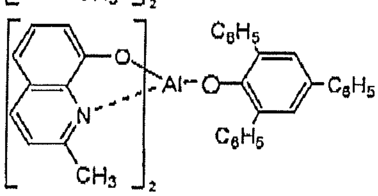
(D-15)

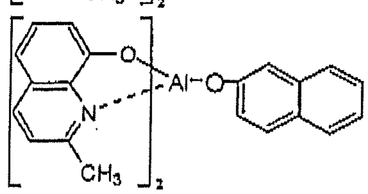
(D-16)

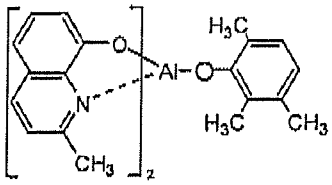
(D-17)

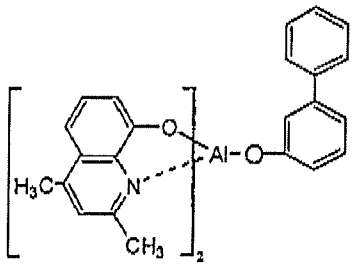
(D-18)

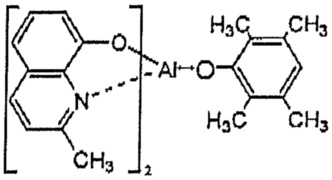
(D-19)

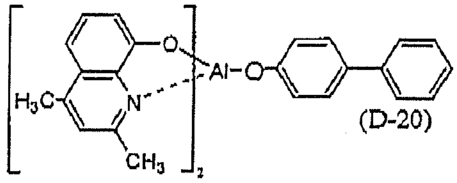
(D-20)

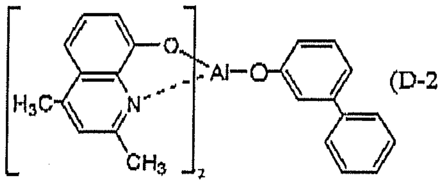
(D-21)

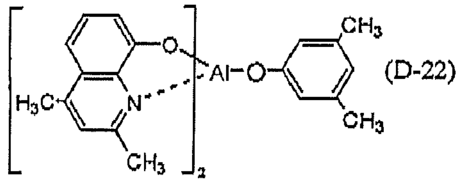
(D-22)

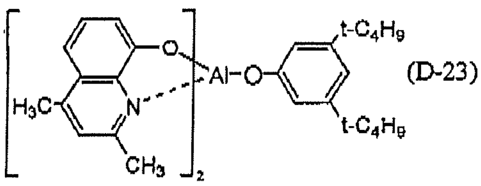
(D-23)

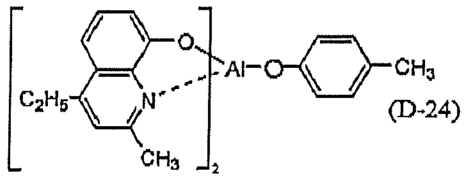
(D-24)

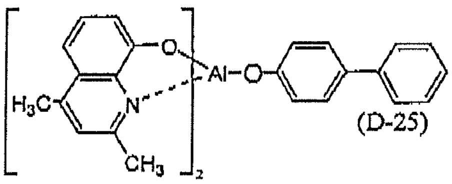
(D-25)

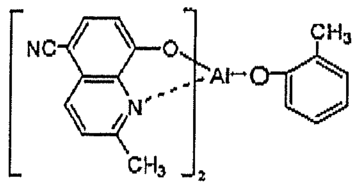
(D-26)

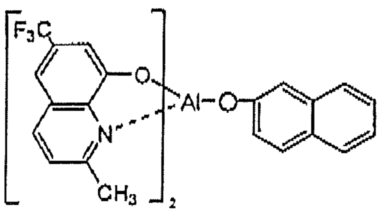
(D-27)

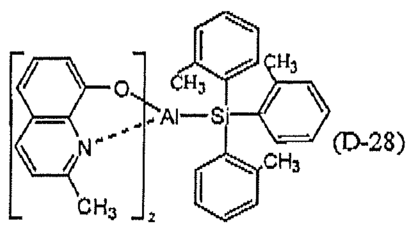
(D-28)

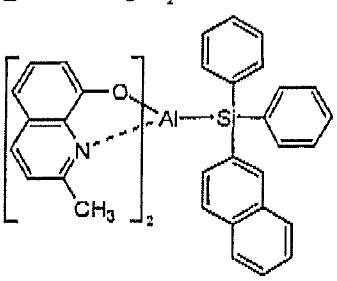
(D-29)

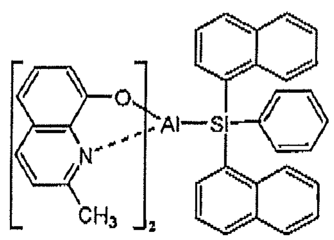
(D-30)

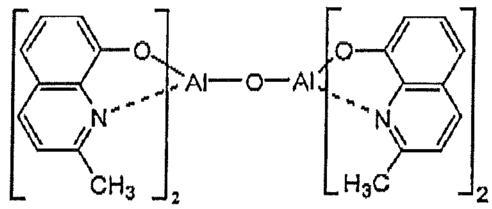

(D-31)

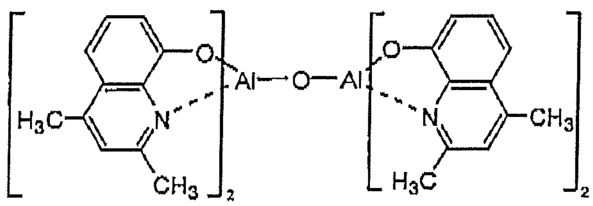

(D-32)

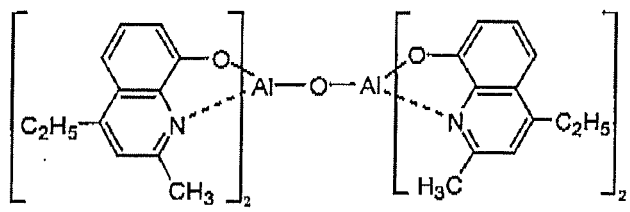

(D-33)

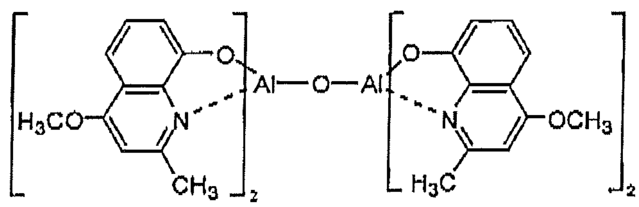

(D-34)

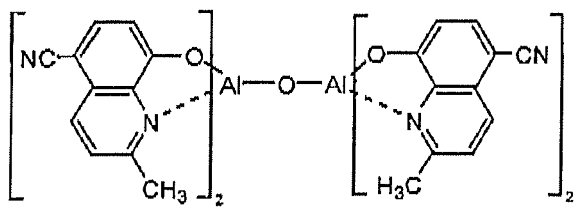

(D-35)

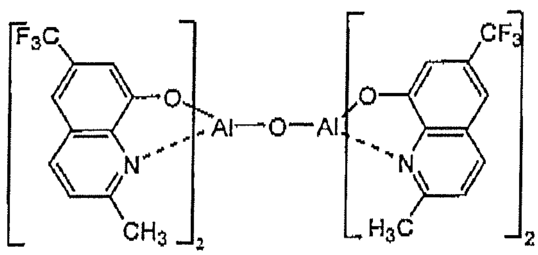

(D-36)

In the organic EL device of the present invention, it is preferable that the electron injecting layer and/or the electron transporting layer comprises a $\pi$-electron-deficient heterocyclic derivative having a nitrogen atom as the main component.

Preferable examples of the $\pi$-electron-deficient heterocyclic derivative having a nitrogen atom include derivatives having a five membered ring having a nitrogen atom selected from benzimidazole ring, benzotriazole ring, pyridinoimidazole ring, pyrimidinoimidazole ring, and pyridazinoimidazole ring and derivatives having a six-membered ring selected from pyridine ring, pyrimidine ring, pyrazine ring and triazine ring. As the five-membered ring having a nitrogen atom, derivatives having structures represented by the following general formula B-I are preferable. As the six-membered ring having a nitrogen atom, derivatives having structures represented by the following general formulae C-I, C-II, C-III, C-IV, C-V and C-VI are preferable. Derivatives having structures represented by general formulae C-I and C-II are more preferable.

(B－I)

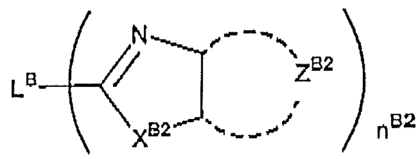

In general formula (B-I), $L^B$ represents a linking group having a valence of two or greater. The group is preferably a linking group formed with an atom or an ion such as carbon atom, silicon atom, nitrogen atom, boron atom, oxygen atom, sulfur atom, a metal atom and a metal ion; more preferably carbon atom, nitrogen atom, silicon atom, boron atom, oxygen atom, sulfur atom, aromatic hydrocarbon rings or aromatic heterocyclic rings; and most preferably carbon atom, silicon atom, aromatic hydrocarbon rings or aromatic heterocyclic rings.

The group represented by $L^B$ may have substituents. As the substituent, alkyl groups, alkenyl groups, alkynyl groups, aromatic hydrocarbon groups, amino groups, alkoxy groups, aryloxy groups, acyl groups, alkoxycarbonyl groups, aryloxycarbonyl groups, acyloxy groups, acylamino groups, alkoxycarbonylamino groups, aryloxycarbonylamino groups, sulfonylamino groups, sulfamoyl groups, carbamoyl groups, alkylthio groups, arylthio groups, sulfonyl groups, halogen atoms, cyano groups and aromatic heterocyclic groups are preferable; alkyl groups, aryl groups, alkoxy groups, aryloxy groups, halogen atoms, cyano groups and aromatic heterocyclic groups are more preferable; alkyl groups, aryl groups, alkoxy groups, aryloxy groups and aromatic heterocyclic groups are still more preferable; and alkyl groups, aryl groups, alkoxy groups and aromatic heterocyclic groups are most preferable.

Examples of the linking group represented by $L^B$ include groups shown in the following:

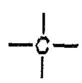 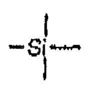 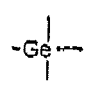 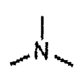 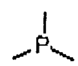 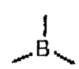

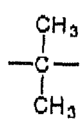 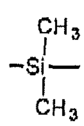 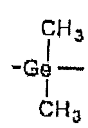 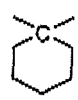 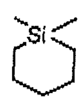 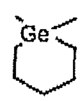

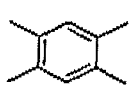 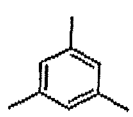 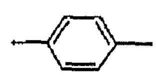 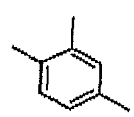 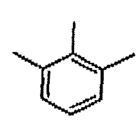

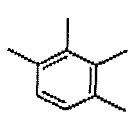 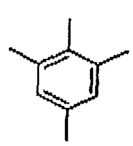 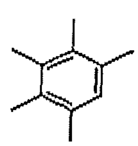 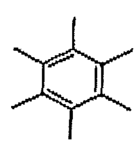

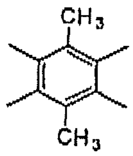
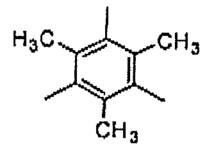
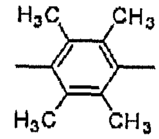
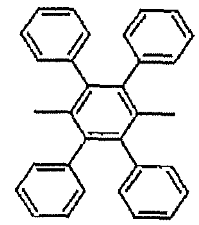

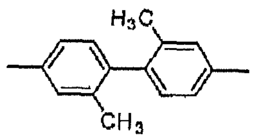
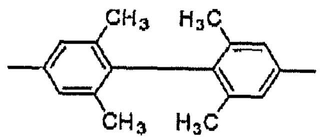
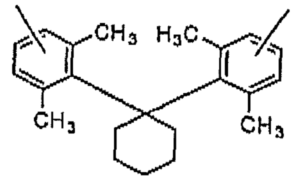

In formula (B-I), $X^{B2}$ represents -O-, -S- or a group represented by =N-$R^{B2}$, $R^{B2}$ represents a hydrogen atom, an aliphatic hydrocarbon group, an aryl group or a heterocyclic group.

The aliphatic hydrocarbon group represented by $R^{B2}$ is a linear, branched or cyclic alkyl group (an alkyl group preferably having 1 to 20 carbon atoms, more preferably having 1 to 12 carbon atoms and most preferably having 1 to 8 carbon atoms, such as methyl group, ethyl group, isopropyl group, t-butyl group, n-octyl group, n-decyl group, n-hexadecyl group, cyclopropyl group, cyclopentyl group and cyclohexyl group), an alkenyl group (an alkenyl group preferably having 2 to 20 carbon atoms, more preferably having 2 to 12 carbon atoms and most preferably having 2 to 8 carbon atoms, such as vinyl group, allyl group, 2-butenyl group and 3-pentenyl group) or an alkynyl group (an alkynyl group preferably having 2 to 20 carbon atoms, more preferably having 2 to 12 carbon atoms and most preferably having 2 to 8 carbon atoms, such as propargyl group and 3-pentynyl group) and is more preferably an alkyl group.

The aryl group represented by $R^{B2}$ is an aryl group having a single ring or a condensed ring preferably having 6 to 30 carbon atoms, more preferably having 6 to 20 carbon atoms and most preferably having 6 to 12 carbon atoms, such as phenyl group, 2-methylphenyl group, 3-methylphenyl group, 4-methylphenyl group, 2-methoxyphenyl group, 3-trifluoromethylphenyl group, pentafluorophenyl group, 1-naphthyl group and 2-naphthyl group.

The heterocyclic group represented by $R^{B2}$ is a heterocyclic group having a single ring or a condensed ring (a heterocyclic group preferably having 1 to 20 carbon atoms, more preferably having 1 to 12 carbon atoms and most preferably having 2 to 10 carbon atoms) and preferably an aromatic heterocyclic group having at least one of nitrogen atom, oxygen atom, sulfur atom and selenium atom. Specifically, the heterocyclic group is a group derived from pyrrolidine, piperidine, piperazine, morpholine thiophene, selenophene, furan, pyrrol, imidazole, pyrazole, pyridine, pyrazine, pyridazine, pyrimidine, triazole, triazine, indole, indazole, purine, thiazoline, thiazole, thiadiazole, oxazoline, oxazole, oxadiazole, quinoline, isoquinoline, phthalazine, naphthylidine, quinoxaline, quinazoline, cinnoline, pteridine, acridine, phenenthroline, phenazine, tetrazole, benzimidazole, benzoxazole, benzothiazole, benzotriazole, tetrazaindene, carbazole and azepine; preferably cyclic group derived from furan, thiophene, pyridine, pyrazine, pyrimidine, pyridazine, triazine, quinoline, phthalazine, naphthylidine, quinoxaline or quinazoline; more preferably a group derived from furan, thiophene, pyridine or quinoline; and most preferably a group derived from quinoline.

The aliphatic hydrocarbon group, the aryl group and the heterocyclic group represented by $R^{B2}$ may have substituents, and examples of the substituent include the substituents described above as the examples of the substituent to the group represented by $L^B$.

As the group represented by $R^{B2}$, alkyl groups, aryl groups and aromatic heterocyclic groups are preferable, aryl groups and aromatic heterocyclic groups are more preferable, and aryl groups are most preferable.

$X^{B2}$ preferably represents -O- or a group represented by =N-$R^{B2}$, more preferably a group represented by =N-$R^{B2}$, and most preferably a group represented by =N-$Ar^{B2}$ {$Ar^{B2}$ represents an aryl group (an aryl group preferably having 6 to 30 carbon atoms, more preferably having 6 to 20 carbon atoms and most preferably having 6 to 12 carbon atoms) or an aromatic heterocyclic group (an aromatic heterocyclic group preferably having 1 to 20 carbon atoms, more preferably having 1 to 12 carbon atoms and most preferably having 2 to 10 carbon atoms), and preferably an aryl group}.

$Z^{B2}$ represents a group of atoms necessary for forming an aromatic ring. The aromatic ring formed with the group of atoms represented by $Z^{B2}$ may be any of an aromatic hydrocarbon ring and an aromatic heterocyclic ring. Examples of the aromatic ring include benzene ring, pyridine ring, pyrazine ring, pyrimidine ring, pyridazine ring, triazine ring, pyrrol ring, furan ring, thiophene ring, selenophene ring, tellurophene ring, imidazole ring, thiazole ring, selenazole

ring, tellurazole ring, thiadiazole ring, oxadiazole ring and pyrazole ring. Among these rings, benzene ring, pyridine ring, pyrazine ring, pyrimidine ring and pyridazine ring are preferable, benzene ring, pyridine ring and pyrazine ring are more preferable, benzene ring and pyridine ring are still more preferable, and pyridine ring is most preferable. The aromatic group ring formed by $Z^{B2}$ may form a condensed ring with other ring or may have a substituent. As the substituent, alkyl groups, alkenyl groups, alkynyl groups, aryl groups, amino groups, alkoxy groups, aryloxy groups, acyl groups, alkoxycarbonyl groups, aryloxycarbonyl groups, acyloxy groups, acylamino groups, alkoxycarbonylamino groups, aryloxycarbonylamino groups, sulfonylamino group, sulfamoyl groups, carbamoyl groups, alkylthio groups, arylthio groups, sulfonyl groups, halogen atoms, cyano groups and heterocyclic groups are preferable, alkyl groups, aryl groups, alkoxy groups, aryloxy groups, halogen atoms, cyano groups and heterocyclic groups are more preferable, alkyl groups, aryl groups, alkoxy groups, aryloxy groups and aromatic heterocyclic groups are still more preferable, and alkyl groups, aryl groups, alkoxy groups and aromatic heterocyclic groups are most preferable.

$n^{B2}$ represents an integer of 1 to 4 and preferably 2 or 3.

Among the compounds represented by the foregoing general formula (B-I), compounds represented by the following general formula (B-II) are preferable.

(B-II)

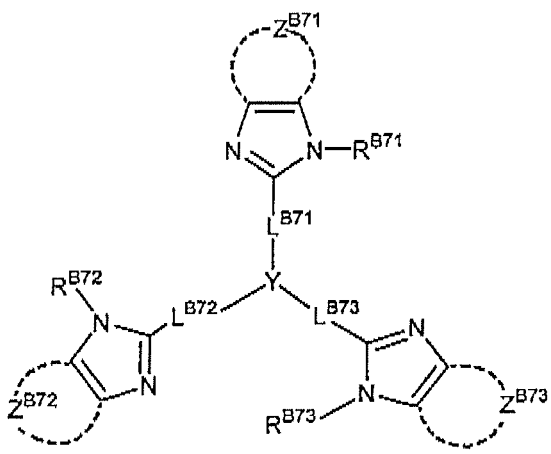

In general formula (B-II), $R^{B71}$, $R^{B72}$ and $R^{B73}$ are each as defined for $R^{B2}$ in general formula (B-I), and the preferable groups are the same as those for $R^{B2}$.

$Z^{B71}$, $Z^{B72}$ and $Z^{B73}$ are each as defined for $Z^{B2}$ in general formula (B-I), and the preferable groups are the same as those for $Z^{B2}$.

$L^{B71}$, $L^{B72}$ and $L^{B73}$ each represent a linking group. Examples of the group include divalent groups derived from the groups described as the examples of the group represented by $L^B$ in general formula (B-I). The linking group is preferably the single bond, a divalent aromatic hydrocarbon cyclic group, a divalent aromatic heterocyclic group or a linking group obtained as a combination of these groups, and more preferably the single bond. The groups represented by $L^{B71}$, $L^{B72}$ and $L^{B73}$ may have substituents. Examples of the substituent include the substituents described as the examples of the substituent for the groups represented by $L^B$ in general formula (B-I).

Y represents a nitrogen atom, 1,3,5-benzenetriyl group or 2,4,6-triazinetriyl group. 1,3,5-benzenetriyl group may have substituents at the 2-, 4- and 6-positions. Examples of the substituent include alkyl groups, aromatic hydrocarbon cyclic groups and halogen atoms.

Examples of the five-membered cyclic derivative having a nitrogen atom which is represented by general formula (B-I) or (B-II) are shown in the following. However, the five-membered cyclic derivative having a nitrogen atom is not limited to the compounds shown as the examples.

($B_E$-1)

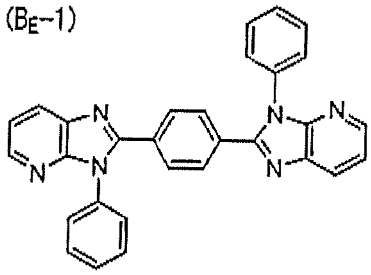

($B_E$-2)

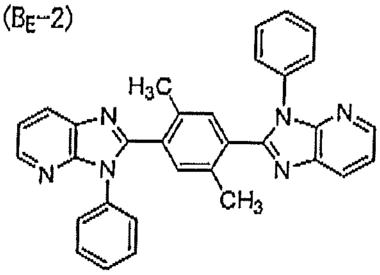

($B_E$-3)

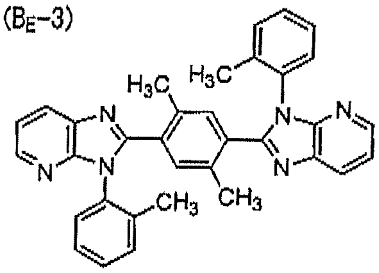

($B_E$-4)

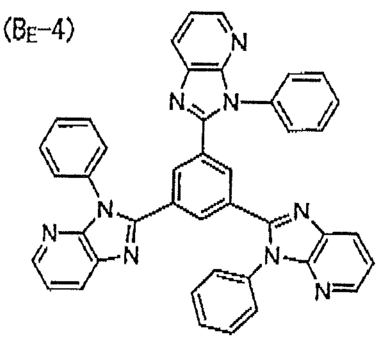

($B_E$-5)

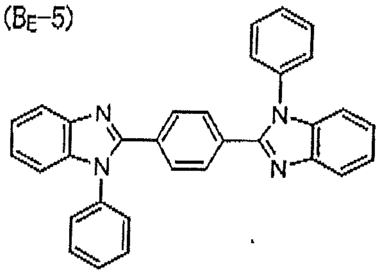

($B_E$-6)

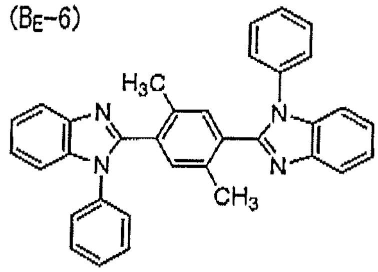

($B_E$-7)

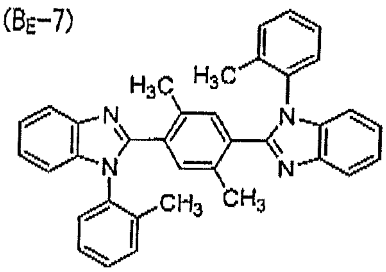

($B_E$-8)

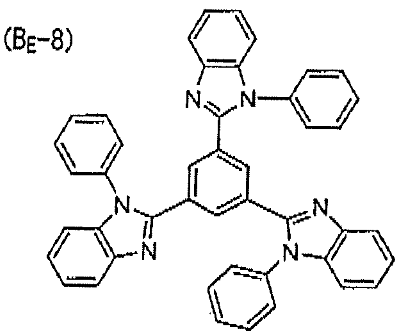

(B$_E$-9)

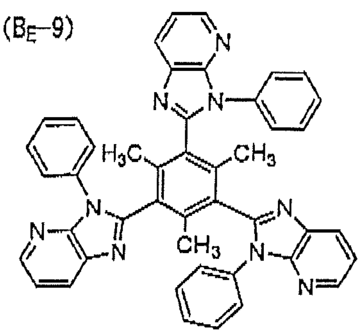

(B$_E$-10)

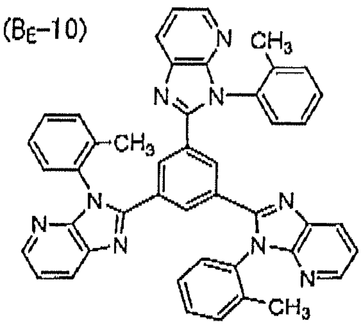

(B$_E$-11)

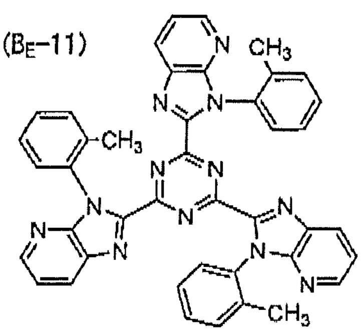

(B$_E$-12)

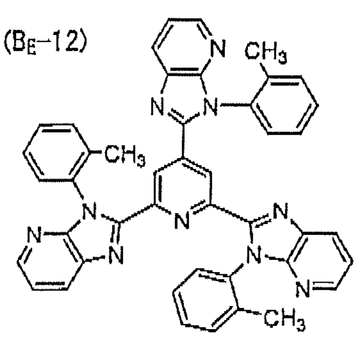

(B$_E$-13)

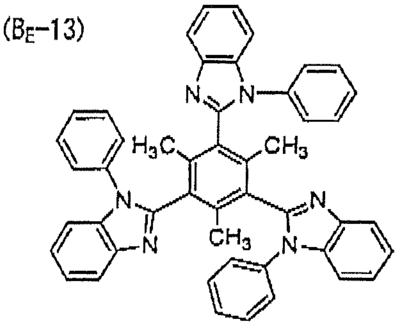

(B$_E$-14)

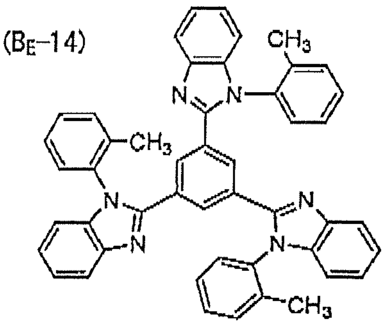

(B$_E$-15)

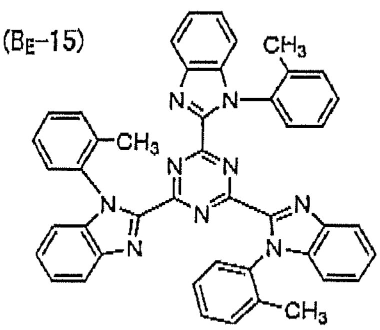

(B$_E$-15)

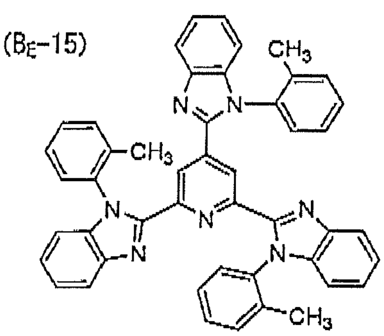

$$(Cz\text{-})_nA \qquad (C\text{-}I)$$

$$Cz(\text{-}A)_m \qquad (C\text{-}II)$$

[In the above formulae, Cz represents a substituted or unsubstituted carbazolyl group, arylcarbazolyl group or carbazolylalkylene group, A represents a group formed with a portion represented by the following general formula (A), and n and m each represent an integer of 1 to 3.

$$(M)_p\text{-}(L)_q\text{-}(M')_r \qquad (A)$$

(M and M' each independently represents a heteroaromatic ring having a nitrogen atom and further having 2 to 40 carbon atoms, which forms a ring with or without a substituent. The groups represented by M and M' may be the same with or different from each other. L represents a single bond, an arylene group having 6 to 30 carbon atoms, a cycloalkylene group of having 5 to 30 carbon atoms or a heteroaromatic ring having 2 to 30 carbon atoms, each may have or may not have a substituent which bonds to the ring. p represents an integer of 0 to 2, q represents an integer of 1 to 2, r represents an integer of 0 to 2, and p+r represents an integer 1 or greater.)]

The bonding mode of general formulae (C-I) and (C-II) can be expressed more specifically as shown in the following table in accordance with the values of the parameters n and m.

| n=m= 1 | n=2 | n=3 | m=2 | m=3 |
|---|---|---|---|---|
| Cz-A | Cz-A-Cz | 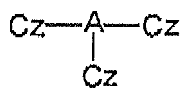 | A-Cz-A | 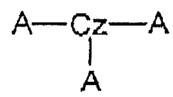 |

The bonding mode of the group represented by general formula (A) can be expressed more specifically as shown by (1) to (16) in the following table in accordance with the values of the parameters p, q and r.

| No | p | q | r | Bonding mode |
|---|---|---|---|---|
| (1) | 0 | 1 | 1 | L-M' |
| (2) | 0 | 1 | 2 | L-M' -M' , M' -L-M' |
| (3) | 0 | 2 | 1 | L-L-M' , L-M' -L |
| (4) | 0 | 2 | 2 | L-L-M' -M' , M' -L-L-M' , 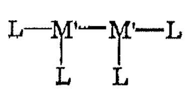 , 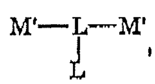 , 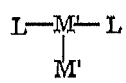 |
| (5) | 1 | 1 | 0 | the same as (1) (replacing M' with M) |
| (6) | 1 | 1 | 1 | M-L-M' |
| (7) | 1 | 1 | 2 | M-L-M' -M' , 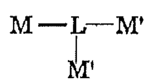 |
| (8) | 1 | 2 | 0 | the same as (3) (replacing M' with M) |
| (9) | 1 | 2 | 1 | M-L-L-M' , L-M-L-M' , M-L-M' -L |

| | | | | |
|---|---|---|---|---|
| (10) | 1 | 2 | 2 | M-L-L-M' -M' , M' -L-M-L-M', M' -M' -L-M-L, 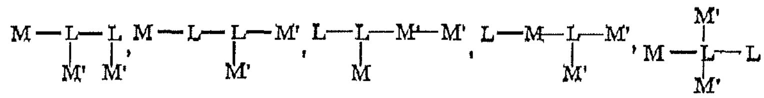 |
| (11) | 2 | 1 | 0 | the same as (2) (replacing M' with M) |
| (12) | 2 | 1 | 1 | the same as (7) (replacing M' with M) |
| (13) | 2 | 1 | 2 | M-M-L-M'-M', 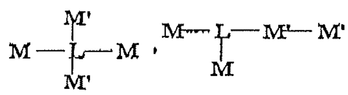 |
| (14) | 2 | 2 | 0 | the same as (4) (replacing M' with M) |
| (15) | 2 | 2 | 1 | the same as (10) (replacing M' with M) |
| (16) | 2 | 2 | 2 | M-M-L-L-M' -M' , 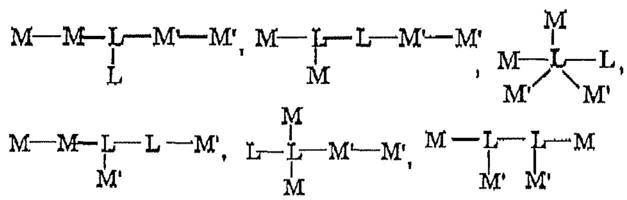 |

When the group represented by Cz is bonded to the group represented by A in the above general formulae (C-I) and (C -II), the group represented by Cz may be bonded to any position of the group or the ring represented by M, L and M' in general formula (A). For example, in the case of m=n-1 (Cz-A) and p=q=r=1 ((6) in the table), the group represented by A becomes a group represented by M-L-M', and the structure is expressed by the three bonding modes of Cz-M-L-M', M-L(-Cz)-M' and M-L-M'-Cz. Similarly, for example, in the case of n=2 (Cz-A-Cz) in general formula (C-I) and p=q=1 and r=2 ((7) in the table), the group represented by A becomes a group represented by M-L-M'-M' or M-L(-M')-M', and the structure is expressed by the following bonding modes:

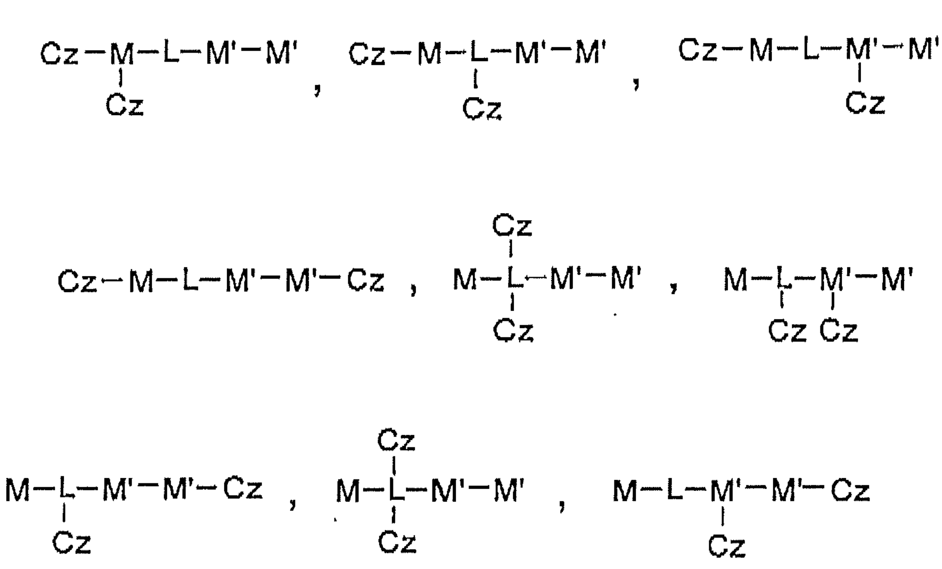

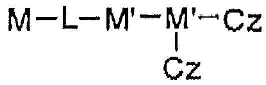 , 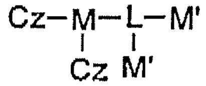 , 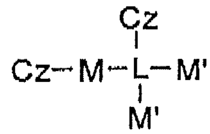 , 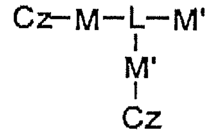

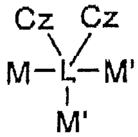 , 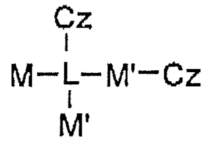 , 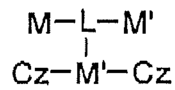 , 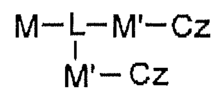

Examples of the six-membered cyclic derivative having a nitrogen atom which is represented by general formula (C-I) or (C-II) are shown in the following. However, the derivative is not limited to the compounds shown as the examples.

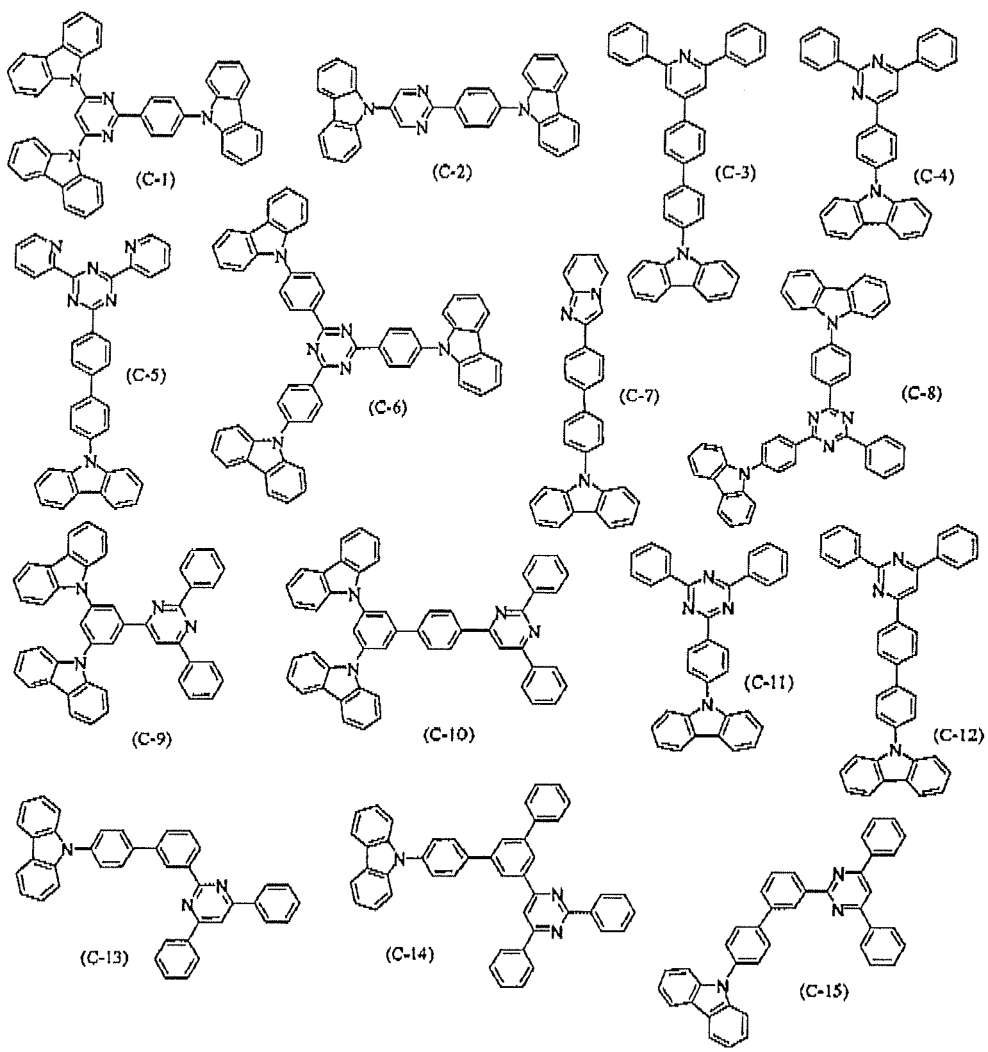

(C-1) (C-2) (C-3) (C-4) (C-5) (C-6) (C-7) (C-8) (C-9) (C-10) (C-11) (C-12) (C-13) (C-14) (C-15)

(C-III)

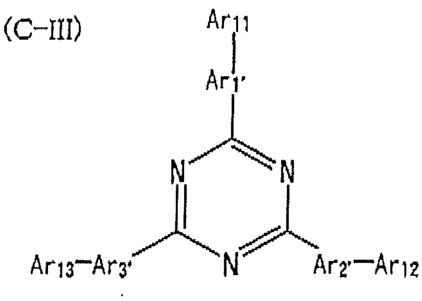

In the above formula, $Ar_{11}$ to $Ar_{13}$ each represent the same group as the group represented by $R^{B2}$ in general formula (B-1), and examples of the group include the groups described as the examples of the group represented by $R^{B2}$. $Ar_{1'}$ to $Ar_{3'}$ each represent a divalent group derived from the group represented by $R^{B2}$ in general formula (B-1), and example of the group include divalent groups derived from the groups described as the examples of the group represented by $R^{B2}$.

Examples of the derivative represented by general formula (C-III) are shown in the following. However, the derivative is not limited to the compounds shown as the examples.

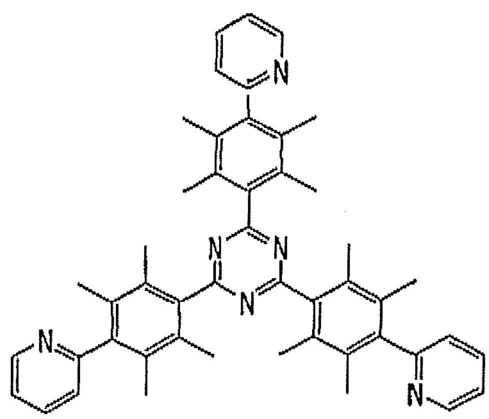

(C-IV)

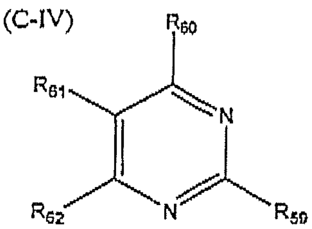

In the above formula, $R_{59}$ to $R_{62}$ each represent the same group as the group represented by $R^{B2}$ in general formula (B-1), and examples of the group include the groups described as the examples of the group represented by $R^{B2}$.

Examples of the derivative represented by general formula (C-IV) are shown in the following. However, the derivative is not limited to the compounds shown as the examples.

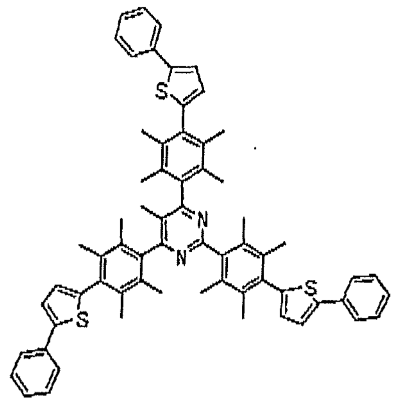

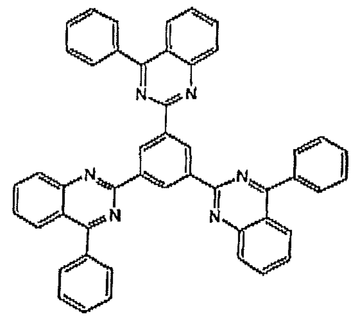

(C-V)

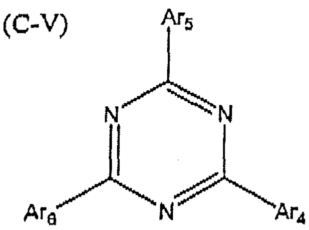

In the above formula, $Ar_4$ to $Ar_8$ each represent the same group as the group represented by $R^{B2}$ in general formula (B-1), and examples of the group include the groups described as the examples of the group represented by $R^{B2}$. Examples of the derivative represented by general formula (C-V) are shown in the following. However, the derivative is not limited to the compounds shown as the examples.

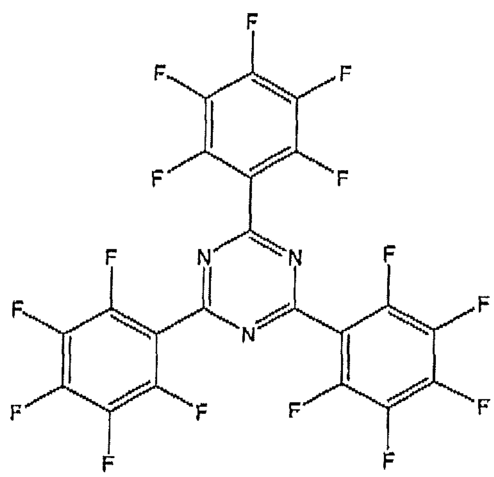

(C-VI)

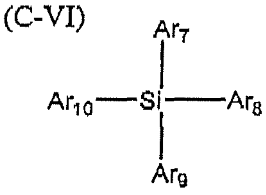

In the above formula, $Ar_7$ to $Ar_{10}$ each represent the same group as the group represented by $R^{B2}$ in general formula (B-1), and examples of the group include the groups described as the examples of the group represented by $R^{B2}$.
Examples of the derivative represented by general formula (C-VI) are shown in the following. However, the derivative is not limited to the compounds shown as the examples.

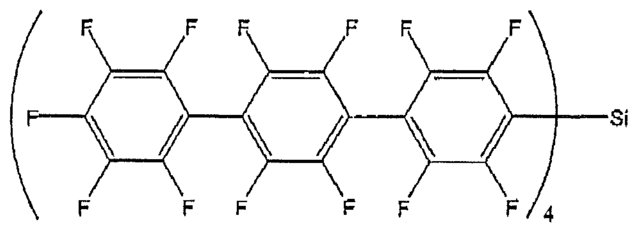

In the organic EL device of the present invention, it is preferable that an inorganic compound of an electrically insulating material or a semiconductor is employed as the substance constituting the electron injecting and transporting layer. When the electron injecting and transporting layer is constituted with an insulating material or a semiconductor, leak of the electric current can be effectively prevented, and the electron injecting property can be improved. As the electrically insulating material, at least one metal compound selected from the group consisting of chalcogenides of alkali metals, chalcogenides of alkaline earth metals, halides of alkali metals and halides of alkaline earth metals is preferable. It is preferable that the electron injecting and transporting layer is constituted with the above metal compound since the electron injecting property can be further improved.
Preferable examples of the chalcogenide of an alkali metal include $Li_2O$, $K_2O$, $Na_2S$, $Na_2Se$ and $Na_2O$. Preferable examples of the chalcogenide of an alkaline earth metal include CaO, BaO, SrO, BeO, BaS and CaSe. Preferable examples of the halide of an alkali metal include LiF, NaF, KF, LiCl, KCl and NaCl. Preferable examples of the halide of an alkaline earth metal include fluoride such as $CaF_2$, $BaF_2$, $SrF_2$, $MgF_2$ and $BeF_2$ and halides other than the fluorides.
Examples of the semiconductor for constituting the electron injecting and transporting layer include oxides, nitrides and oxynitrides containing at least one element selected from Ba, Ca, Sr, Yb, Al, Ga, In, Li, Na, Cd, Mg, Si, Ta, Sb and Zn, which are used singly or in combination of two or more, It is preferable that the inorganic compound for constituting the electron transporting layer is in the form of a crystallite or amorphous insulating thin film. When the electron transporting layer is constituted of the above insulating thin film, a more uniform thin film can be formed and defective pixels such as dark spots can be decreased. Examples of the inorganic compound include the alkali metal chalcogenides, the alkaline earth metal chalcogenides, the alkali metal halides and the alkaline earth metal halides which are described above.
In the organic EL device of the present invention, the electron injecting layer and/or the electron transporting layer may contain a reducing dopant having a work function of 2.9 eV or smaller. In the present invention, the reducing dopant is a compound which increases the efficiency of injecting electrons.
In the present invention, it is preferable that the reducing dopant is added into an interfacial region between the cathode and the organic thin film layer. At least a portion of the organic layer contained in the interfacial region is reduced to form anions. At least one substance selected from the group consisting of alkali metals, oxides of alkaline earth metals, alkaline earth metals, rare earth metals, oxides of alkali metals, halides of alkali metals, oxides of alkaline earth metals, halides of alkaline earth metals, oxides of rare earth metals, halides of rare earth metals, complex compounds of alkali metals, complex compounds of alkaline earth metals and complex compounds of rare earth metals is preferable as the reducing dopant. More specifically, at least one alkali metal selected from the group consisting of Na (the work function: 2.36 eV), K (the work function: 2.28 eV), Rb (the work function: 2.16 eV) and Cs (the work function: 1.95 eV) and at least one alkaline earth metal selected from the group consisting of Ca (the work function: 2.9 eV), Sr (the work function: 2.0 to 2.5 eV) and Ba (the work function: 2.52 eV), are preferable. Substances having a work function of 2.9 eV are preferable. Among the above substances, at least one alkali metal selected from the group consisting of

K, Rb and Cs is more preferable, Rb and Cs are still more preferable, and Cs is most preferable as the reducing dopant. These alkali metals have great reducing ability, and the luminance of the emitted light and the life of the organic EL device can be increased by addition of a relatively small amount into the electron injecting zone.

As the oxide of an alkaline earth metal, for example, BaO, SrO, CaO and $Ba_xSr_{1-x}O$ (0<x<1) and $Ba_xCa_{1-x}$ (0<x<1) which are obtained by mixing the oxides are preferable. Examples of the alkali metal oxide or alkali metal fluoride include LiF, $Li_2O$, NaF, etc. The alkali metal complex compound, the alkaline earth metal complex compound and the rare earth metal complex compound are not particularly limited as long as the compound contains at least one of the alkali metal ions, the alkaline earth metal ions and the rare earth metal ions. Examples of the ligand include quinolinol, benzoquinolinol, acrydinol, phenanthridinol, hydroxyphenyloxazole, hydroxyphenylthiazole, hydroxydiaryloxadiazoles, hydroxydiarylthiadiazoles, hydroxyphenylpyridine, hydroxyphenylbenzimidazole, hydroxybenzotriazole, bipyridyl, phenanthroline, phthalocyanine, porphyrin, cyclopentadiene, β-diketones, azomethines and derivatives of these ligands. However the ligand is not limited to those described above.

As for the form of the reducing dopant, it is preferable that the reducing dopant is formed as a layer or islands. In the case where the layer of the reducing dopant is formed, a preferable film thickness is from 0.05 to 8 nm.

As the process for forming the electron injecting and transporting layer comprising the reducing dopant, it is preferable that a light emitting material for forming the interfacial region or an organic substance as the electron injecting material is simultaneously vapor deposited with the reducing dopant while the reducing dopant is vapor deposited in accordance with the vapor deposition process using the resistance heating so that the reducing dopant is dispersed in the organic substance. The concentration of the dispersion is 100:1 to 1:100 and preferably 5:1 to 1:5 as the ratio of the amounts by mole. When a layer of the reducing dopant is formed, a layer of a light emitting material or an electron injecting material which is the organic layer at the interface is formed. Then, the reducing dopant alone is vapor deposited in accordance with the vapor deposition process using the resistance heating, and a layer preferably having a thickness of 0.5 to 15 nm is formed. When islands of the reducing dopant are formed, a layer of a light emitting material or an electron injecting material which is the organic layer at the interface is formed. Then, the reducing dopant alone is vapor deposited in accordance with the vapor deposition process using the resistance heating, and islands preferably having a thickness of 0.05 to 1 nm are formed.

The light emitting layer in the organic EL device of the present invention has the function of injecting holes from the anode or the hole injecting layer and injecting electrons from the cathode or the electron injecting layer when an electric field is applied, the function of transferring the injected charges (electrons and holes) by the force of the electric field, and the function of providing the field for recombination of electrons and holes, leading the recombination to the emission of light. It is preferable that the light emitting layer in the organic EL device of the present invention contains at least the metal complex compound of the present invention and may contain a host material for using the metal complex compound as the guest material. Examples of the host material include materials having the skeleton structures of carbazole, a diarylamine, pyridine, pyrazine, triazine and an arylsilane. It is preferable that T1 (the energy level of the lowest excited state of the triplet) is greater than T1 of the guest material. The host material may be a low molecular weight compound or a macromolecular compound. A light emitting layer in which the host material is doped with the light emitting material can be formed by the simultaneous vapor deposition of the host material and the light emitting material such as the metal complex compound described above.

The process for forming the layers described above in the organic EL device of the preset invention is not particularly limited. Various processes such as the vacuum vapor deposition process, the LB process, the vapor deposition process using the resistance heating, the electron beam process, the sputtering process, the molecular accumulation process, the coating process (such as the spin coating process, the casting process and the dip coating process), the ink-jet process and the printing process can be used. In the present invention, the coating process is preferable.

The organic thin film layer containing metal complex compound of the present invention can be formed in accordance with a conventional process such as the vacuum vapor deposition process, the molecular beam epitaxy process (the MBE process), or a coating process using a solution prepared by dissolving the metal complex compound into a solvent. Examples of the coating process include the dipping process, the spin coating process, the casting process, the bar coating process and the roller coating process.

In the above coating process, preparing a coating solution by dissolving the metal complex compound of the present invention into a solvent, and by applying the coating solution over the surface of a predetermined layer (or, electrode), followed by drying may form the organic thin film layer. In the coating solution, a resin may be contained either by dissolving a solvent or by dispersing into the solvent. As the resin, macromolecules based on non-conjugated compounds (for example, polyvinyl carbazole) and macromolecules based on conjugated compounds (for example, polyolefin-based macromolecules) can be used. Examples of the resin include polyvinyl chloride, polycarbonates, polystyrene, polymethyl methacrylate, polybutyl methacrylate, polyesters, polysulfone, polyphenylene oxide, polybutadiene, poly(N-vinylcarbazole), hydrocarbon resins, ketone resins, phenoxy resins, polyamides, ethylcellulose, vinyl acetate resins, ABS resins, polyurethanes, melamine resins, unsaturated polyester resins, alkyd resins, epoxy resins and silicone resins.

The thickness of each organic layer in the organic EL device of the present invention is not particularly limited. In general,

an excessively small thickness tends to form defects such as pinholes, and an excessively great thickness requires application of a high voltage to decrease the efficiency. In general, it is preferable that the thickness is in the range of several nm to 1 μm.

EXAMPLES

The present invention will be described with reference to examples in the following.

Example 1 (Synthesis of Compound (A-1))

Compound (A-1) was synthesized in accordance with the following process of reactions:

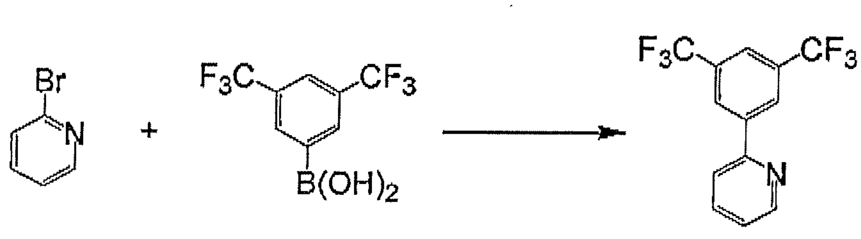

(L-1)

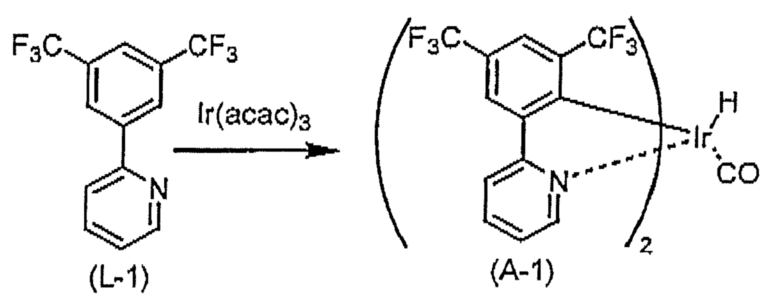


(L-1) (A-1)

(1) Synthesis of ligand (L-1)

Under a stream of argon, tetrakis(triphenylphosphine)palladium in an amount of 1.2 mmol (1.38 g), 3,5-bis (trifluoromethyl)phenylboronic acid in an amount of 39.7 mmol (10.2 g), 2-bromopyridine in an amount of 39.7 mmol (6.27 g), sodium carbonate in an amount of 99.3 mmol (100 mL) and 1,2-dimethoxyethane in an amount of 500 mL were placed into a flask having a capacity of 1L and the resultant solution was reacted with reflux for 8 h. After condensing the reacted solution, the residue dissolved in 150 mL of methylene chloride was washed twice with 200 mL of water. An organic layer obtained by separation was dried over sodium sulfate. A solid matter obtained by condensation after filtration was purified through silica column chromatography (hexane : methylene chloride = 5:5) to obtain 9.8 g of the aimed substance L-1 (yield: 85 %).
$^1$H-NMR($CDCl_3$): δ 8.76 (1H), δ 8.48 (2H), δ 7.80-7.92 (3H), δ 7.26-7.42 (1H)

(2) Synthesis of Complex (A-1)

Under a stream of argon, tris(acetylacetonato)iridium ($Ir(acac)_3$) in an amount of 1.5 mmol (0.73g), above Complex (L-1) in an amount of 7.5 mmol (2.2g) and glycerin in an amount of 50 mL were placed into a flask having a capacity of 100 mL, and the resultant mixture was heated at 220˚C under the microwave irradiation for 30 min. The resultant mixture was thrown into 100 mL of water and after stirring the resultant solution at a room temperature for several minutes, an extraction was carried out with 250 mL of methylene chloride. Further, the methylene chloride layer was washed twice with 100 mL of water, dried over magnesium sulfate. The mixture obtained by condensation after drying was purified through silica column chromatography (methylene chloride) to obtain 0.06 g (10 %) of the aimed substance A-1. As a result of analyzing light emission spectrum about the synthesized Compound A-1, it was confirmed that $\lambda_{mux}$ of light emission was 457 nm and 487 nm at a room temperature.

$^1$H-NMR ($CDCl_3$): δ 8.27 (1H), δ 8.15 (1H), δ 8.05-8.1 (3H), δ 7.96 (1H), δ 7.82-7.85 (2H), δ 7.77 (1H), δ 7.57

(1H), δ 7.05 (1H), δ 8.93 (1H), δ -15.97(1H)
IR: 220101cm$^{-1}$, 2037.7cm$^{-1}$
FD-MS: calcd for $IrC_{27}H_{13}F_{12}N_{20}$=801, found, m/z=801 (100)

Example 2 (Synthesis of Compound (A-13))

Compound (A-13) was synthesized in accordance with the following reaction formula:

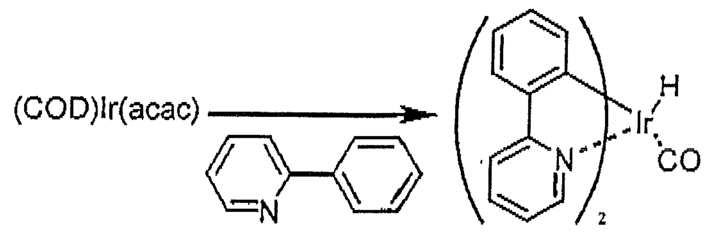


(A-13)

Under a stream of argon, (1,5-cyclooctadiene)(acetylacetonato)-iridium ((COD)Ir(acac)) in an amount of 1.25 mmol (0.5 g), 2-phenylpyridine in an amount of 4.38 mmol (0.679 g) and 2-ethoxyethanol as a solvent in an amount of 20 mL were placed into a flask having a capacity of 100 mL, and the resultant solution was refluxed with heating for 2 h. Condensing the reacted solution and dissolving the resultant solid using 20 mL of methylene chloride, undissolved solid was separated by filtration. Adding 50 mL of hexane into the methylene chloride solution, a solid was precipitated. Filtering the liquid component, and in accordance with drying the filtered precipitant under a reduced pressure, a crude product was obtained. Dissolving the crude product into methylene chloride, and purifying the resultant solution through silica column chromatography (methylene chloride), 0.22 g (33 %) of the aimed substance A-13 was obtained. As a result of analyzing light emission spectrum about the synthesized Compound A-13, it was confirmed that $\lambda_{max}$ of light emission was 458 nm and 489 nm at a room temperature.

$^1$H-NMR ($CDCl_3$): δ 9.12 (1H), δ 7.88-7.99 (4H), δ 7.8 (1H), δ 7.64-7.68 (2H), δ 7.6 (1H), δ 7.25 (1H), δ 7.18 (2H), δ 6.92 (1 H), δ 6.86 (1H), δ 6.8 (1H), δ 6.47 (1H), δ -15.53(1H)
FD-MS: calcd for $IrC_{23}H_{17}N_{20}$=529, found, m/z=529 (100)

Example 3 (Synthesis of Compound (A-2))

Compound (A-2) was synthesized in accordance with the following process of reactions:

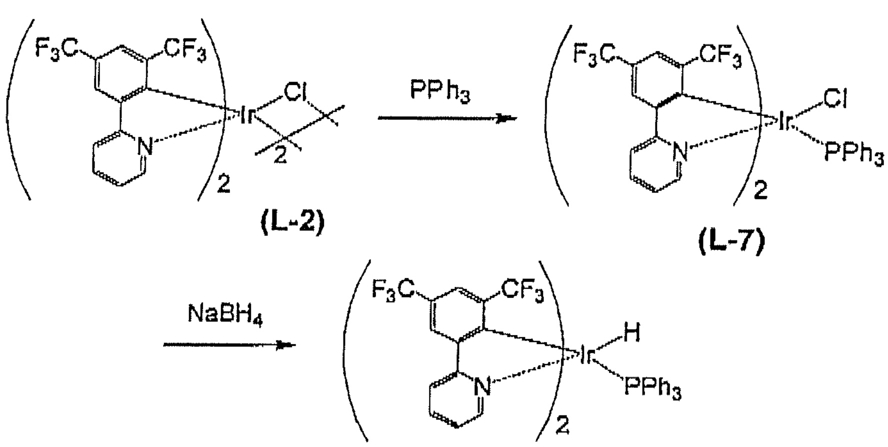


(L-2) (L-7)

(A-2)

(1) Synthesis of Complex (L-7)

Under a stream of argon, Complex (L-2) in an amount of 1.23 mmol (2.0 g), triphenylphosphine in an amount of 3.7 mmol (0.97 g) and 1,2-dichloromethane in an amount of 30 mL were placed into a flask having a capacity of 100 mL, and after the resultant mixture was reacted at a room temperature for 3 h, it was further reacted with refluxing for 2 h. Condensing the reacted solution and washing the resultant solid with excess hexane, 2.4 g of an aimed substance L-7 was obtained (yield: 90 %).
FD-MS: calcd for $IrC_{44}H_{27}ClF_{12}N_2P$=1070, found, m/z=1070 (100)

(2) Synthesis of Complex (A-2)

Under a stream of argon, Complex (L-7) in an amount of 0.74 mmol (0.8 g) and ethanol in an amount of 50 mL were placed into a flask having a capacity of 100 mL, and the resultant mixture was refluxed with heating. On the other hand, taking sodium borohydride in an amount of 7.4 mmol (0.28g) into another flask having a capacity of 20 mL, it was dissolved into 10 mL of ethanol and the resultant solution was added to the above L-3 ethanol solution slowly with a syringe. The resultant solution was refluxed with heating and reacted for 40 min. Condensing the reacted solution and dissolving the resultant solid using 200 mL of methylene chloride, undissolved solid was separated by filtration. The solid obtained by condensing the solvent again was purified through silica column chromatography (methylene chloride) to obtain 0.78 g (62 %) of the aimed substance A-2.
$^1$H-NMR ($CDCl_3$): δ 8.23 (2H), δ 8.13 (1H), δ 7.98 (1H), δ 7.84 (1H), δ 7.77 (1H), δ 7.68 (1H), δ 7.6 (1H), δ 7.47 (1H), δ 7.38 (1H), δ 7.21·7.28 (8H), δ 7.03-7.1 (7H), δ 6.09 (2H), δ -10.3(1H)
FD-MS: calcd for $IrC_{44}H_{26}ClF_{12}N_2P$=1035, found, m/z=1035 (100)

Fabrication Example of the Device

Example 1

A glass substrate of 25 mm×75 mm×1.1 mm thickness having an ITO transparent electrode was cleaned by application of ultrasonic wave in isopropyl alcohol for 5 minutes and then by exposure to ozone generated by ultraviolet light for 30 minutes. The cleaned glass substrate having the transparent electrode was attached to a substrate holder of a vacuum vapor deposition apparatus. On the surface of the cleaned substrate at the side having the transparent electrode, a film of TPD232 below having a thickness of 85 nm was formed as to cover the transparent electrode. The formed film of TPD232 worked as the hole injecting layer. Subsequently, on the formed film of TPD232, 4,4',4"-tris (carbazole-9-yl)-triphenylamine (TCTA) below was formed into a thin film layer with a film thickness of 10 nm. The formed film of TCTA worked as the hole transporting layer. On the formed film of TCTA, a film having a thickness of 30 nm of Compound (H) below, as a host material was vapor deposited to form a light emitting layer. Simultaneously, the above Metal complex Compound (A-1) was added as a phosphorescent Ir metal complex dopant. A concentration of Metal complex Compound (A-1) in the light emitting layer was 7.5 % by weight. The formed film worked as a light emitting layer. On the film formed above, a film of BAlq below having a thickness of 25 nm was formed. The formed film of BAlq worked as the electron transporting layer. On the film formed above, a film of Alq below having a thickness of 5 nm was formed. The film of Alq worked as the electron injecting layer. Subsequently, lithium fluoride was deposited up to 0.1 nm in thickness and then, aluminum was deposited up to 150 nm in thickness. The Al/LiF worked as a cathode. An organic EL device was fabricated in the manner described above.
The device fabricated above was sealed and examined by feeding electric current. Blue light (458 nm, 484 nm) was emitted at a luminance of 102 cd/m$^2$ under a voltage of 6.5 V and a current density of 0.62 mA/cm$^2$. The current efficiency was 19.3 cd/A.
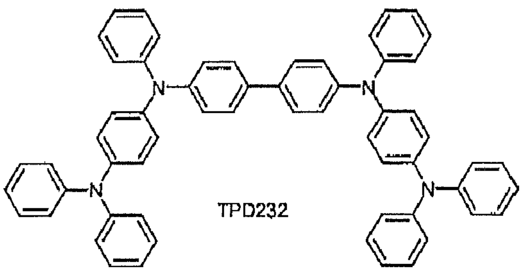
TPD232

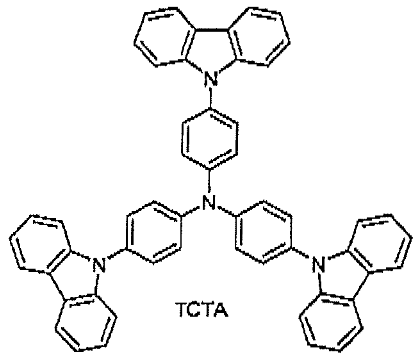
TCTA

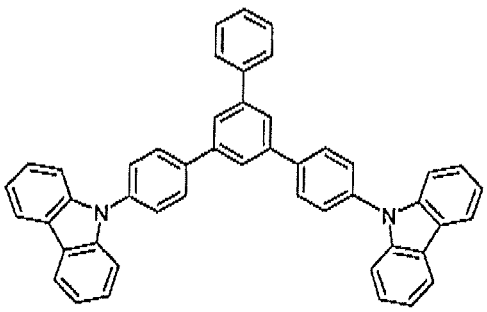
(Compound H)

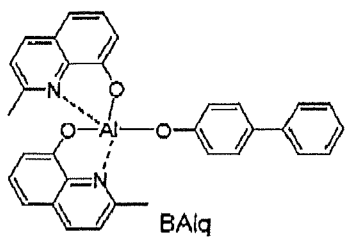
BAlq

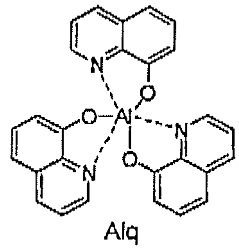
Alq

Comparative Example 1

A device was fabricated in the same manner as Example 1 except that Compound Y was employed as the dopant instead of Compound (A-1). The device fabricated above was examined by feeding electric current. Bluish green light (471 nm) was emitted at a luminance of 102 $cd/m^2$ under a voltage of 7.5 V and a current density of 0.80 $mA/cm^2$. The current efficiency was 12.8 cd/A.

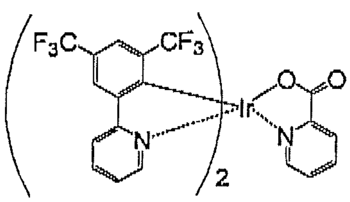
(Compound Y)

An introduction of a monodentate ligand instead of the bidentate chelate compound conventionally used as a ligand, an organic electroluminescence device with an enhanced efficiency and exhibiting short wavelength light emission can be fabricated.

INDUSTRIAL APPLICABILITY

As described specifically in the above, the metal complex compound of the present invention can be used as the material for organic EL devices. The organic EL device using the compound exhibits a great efficiency of light emission. The device can be advantageously applied to the fields such as various display devices, displays, back lights, light sources for illumination, marking signs, sign boards and interior products, and is particularly suitable as a display device for color display.

**Claims**

**1.** A metal complex compound represented by following general formula (1).

$$(L_1)_m M(L_2)_n(L_3)_k \qquad (1)$$

wherein M represents a metal atom of iridium (Ir), platinum (Pt) or rhodium (Rh); $L_1$ represents a bidentate ligand, $L_2$ and $L_3$ represent monodentate ligands different from each other and being not bonded mutually;
m, n and k each represents an integer of 1 or 2, and m+n+k represents an integer of 3 to 5;
the partial structure represented by $(L_1)_mM$ is represented by following general formula (2):

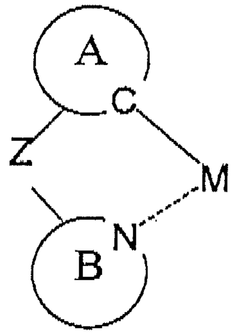

(2)

wherein N represents a nitrogen atom, C represents a carbon atom, ring A represents an aryl group having 6 to 50 ring carbon atoms which may have substituents, ring B represents an aromatic heterocyclic group having 3 to 50 ring atoms including a nitrogen atom which may have substituents, ring A and ring B are bonded with covalent bonds via Z; Z represents a single bond, -O-, -S-, -CO-, - $(CR'R'')_a$-, - $(SiR'R'')_a$- or -NR'-;
R' and R'' each independently represents a hydrogen atom, an aryl group having 6 to 50 ring carbon atoms which may have substituents, an aromatic heterocyclic group having 3 to 50 ring atoms which may have substituents, or an alkyl group having 1 to 30 carbon atoms which may have substituents;
a represents an integer of 1 to 10; and the atoms and groups represented by R' and R'' may be the same with or different from each other;
$L_2$ is a monovalent group which forms a covalent bond with M, and represents a hydrogen atom, an alkyl group having 1 to 30 carbon atoms which may have substituents, an aryl group having 6 to 50 ring carbon atoms which may have substituents, or a silyl group with an alkyl group having 1 to 30 carbon atoms which may have substituents; and
$L_3$ represents a group forming a coordinate bond with M.

**2.** A metal complex compound according to Claim 1, wherein the partial structure represented by $(L_1)_mM$ is a partial structure represented by any one of following general formulae:

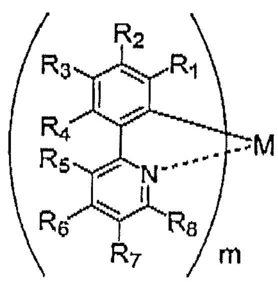

(3)

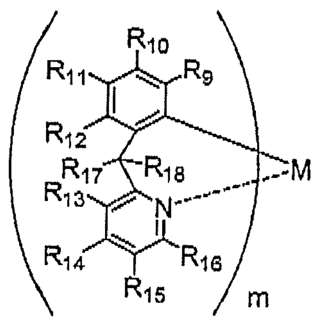

(4)

wherein M and m are same as described above;
$R_1$ to $R_{18}$ each independently represents a hydrogen atom, an alkyl group having 1 to 30 carbon atoms which may have substituents, a halogenated alkyl group having 1, to 30 carbon atoms which may have substituents, an alkoxy group having 1 to 30 carbon atoms which may have substituents, a heterocyclic group having 3 to 50 ring atoms which may have substituents, an aryl group having 6 to 50 ring carbon atoms which may have substituents, an aryloxy group having 6 to 40 ring carbon atoms which may have substituents, an aralkyl group having 7 to 40 carbon atoms which may have substituents, an alkenyl group having 2 to 30 carbon atoms which may have substituents,

an arylamino group having 6 to 80 ring carbon atoms which may have substituents, an alkylamino group having 1 to 60 carbon atoms which may have substituents, an aralkylamino group having 7 to 80 carbon atoms which may have substituents, a silyl group with alkyl group having 1 to 30 carbon atoms which may have substituents, an arylsilyl group having 6 to 40 carbon atoms which may have substituents, a halogen atom, a cyano group, a nitro group, $-S(R)O_2$ or $-S(R)O$ wherein R represents a substituent, and adjacent groups represented by $R_1$ to $R_8$ and $R_9$ to $R_{16}$ may be bonded each other to form a cyclic structure.

**3.** A metal complex compound according to Claim 1 or 2, wherein the partial structure represented by $M(L_2)_n(L_3)_k$ is a partial structure represented by any one of following general formulae:

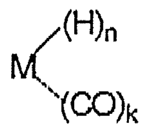 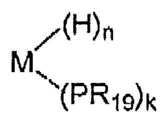 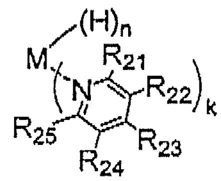 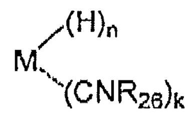

(5) (6) (7) (8)

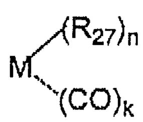 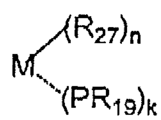 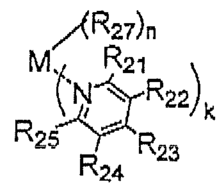 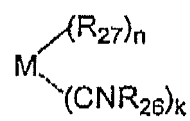

(9) (10) (11) (12)

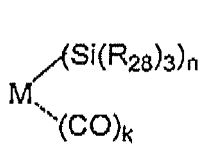 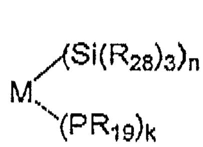 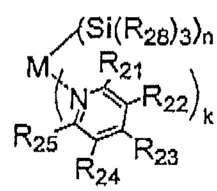 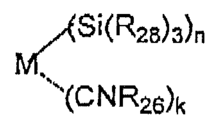

(13) (14) (15) (16)

wherein M, n and k are same as described above;
$R_{19}$ to $R_{26}$ and $R_{28}$ each independently represents a hydrogen atom, an alkyl group having 1 to 30 carbon atoms which may have substituents, a halogenated alkyl group having 1 to 30 carbon atoms which may have substituents, an alkoxy group having 1 to 30 carbon atoms which may have substituents, a heterocyclic group having 3 to 50 ring atoms which may have substituents, an aryl group having 6 to 50 ring carbon atoms which may have substituents, an aryloxy group having 6 to 40 ring carbon atoms which may have substituents, an aralkyl group having 7 to 40 carbon atoms which may have substituents, an alkenyl group having 2 to 30 carbon atoms which may have substituents, an arylamino group having 6 to 80 ring carbon atoms which may have substituents, an alkylamino group having 1 to 60 carbon atoms which may have substituents, an aralkylamino group having 7 to 80 carbon atoms which may have substituents, a silyl group with alkyl group having 1 to 30 carbon atoms which may have substituents, an arylsilyl group having 6 to 40 carbon atoms which may have substituents, a halogen atom, a cyano group, or a nitro group, and
adjacent groups represented by $R_{21}$ to $R_{25}$ may be bonded each other to form a cyclic structure;
further, $R_{27}$ represents an alkyl group having 1, to 30 carbon atoms which may have substituents, a halogenated alkyl group having 1 to 30 carbon atoms which may have substituents, a heterocyclic group having 3 to 20 ring atoms which may have substituents, an aryl group having 6 to 50 ring carbon atoms which may have substituents,

an aralkyl group having 7 to 40 carbon atoms which may have substituents, or an alkenyl group having 2 to 30 carbon atoms which may have substituents.

**4.** A metal complex compound according to Claim 3, wherein the partial structure represented by $(L_1)_mM$ which is represented by the general formula (2) is a partial structure represented by any one of the above general formula (3) or (4) and, wherein the partial structure represented by $M(L_2)_n(L_3)_k$ is a partial structure represented by any one of the above general formulae (5) to (16).

**5.** A metal complex compound according to Claim 3, wherein the partial structure represented by $(L_1)_mM$ which is represented by the above general formula (2) is a partial structure represented by any one of the above general formula (3) or (4) and, wherein the partial structure represented by $M(L_2)_n(L_3)_k$ is a partial structure represented by any one of the above general formulae (5) to (16), wherein m is an integer of 2, n and k are each an integer of 1, and M is an iridium atom.

**6.** An organic electroluminescence device which is composed of one or more organic thin film layers including at least one light emitting layer sandwiched between an anode and a cathode, wherein at least one of the organic thin film layers comprises the metal complex compound according to any one of Claims 1 to 5.

**7.** An organic electroluminescence device according to Claim 6, wherein the light emitting layer comprises the metal complex compound according to any one of Claims 1 to 5 as a light emitting material.

**8.** An organic electroluminescence device according to Claim 6, wherein the light emitting layer comprises a metal complex compound according to any one of Claims 1 to 5 as a dopant.

**9.** An organic electroluminescence device according to Claim 6, wherein at least one of an electron injecting layer and an electron transporting layer is sandwiched between the light emitting layer and the cathode, and wherein at least one of the electron injecting layer and the electron transporting layer comprises a π-electron-deficient heterocyclic derivative having a nitrogen atom as an essential component.

**10.** An organic electroluminescence device according to Claim 6, wherein a reducing dopant is added into an interfacial region of the cathode and the organic thin film layer.

**11.** An organic electroluminescence device according to Claim 6, wherein the layer comprising the metal complex compound according to any one of Claims 1 to 5 between the anode and the cathode is formed as a thin film layer in accordance with a coating process.

**12.** A production method for preparing the metal complex compound according to any one of Claims 1 to 5, wherein a metal complex compound represented by following general formula (C) or (D) is employed as a material metal compound:

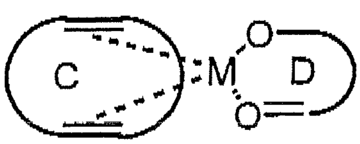

(C)

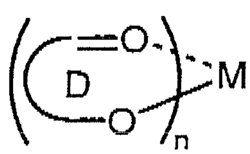

(D)

wherein M represents a metal atom of iridium (Ir), platinum (Pt) or rhodium (Rh) and n represents an integer of 2 or 3; ring C represents a cyclic diolefin compound having 8 to 20 carbon atoms, and wherein a part except M constituting ring D is a compound containing two oxygen atoms and having 5 to 23 carbon atoms.

**13.** A production method for preparing the metal complex compound according to Claim 12, wherein the material metal compound is represented by any one of following general formulae:

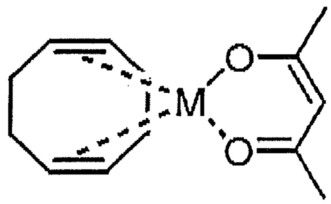

(COD)M(acac)

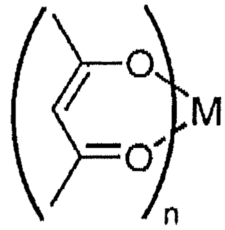

M(acac)$_n$

wherein M and n are same as described above.

**INTERNATIONAL SEARCH REPORT**

International application No.
PCT/JP2006/303548

A. CLASSIFICATION OF SUBJECT MATTER
***C07F15/00***(2006.01), ***C09K11/06***(2006.01), ***H01L51/50***(2006.01)

According to International Patent Classification (IPC) or to both national classification and IPC

B. FIELDS SEARCHED

Minimum documentation searched (classification system followed by classification symbols)
C07F15/00, C09K11/06, H01L51/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)
CAplus(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>Y | CHASSOT, L. et al., Photochemical preparation of luminescent platinum(IV) complexes via oxidative addition on luminescent platinum(II) complexes, Journal of the American Chemical Society, 1986, 108(19), pages 6084 to 6085, Table I. | 1-11<br>12-13 |
| X<br>Y<br>A | OWEN, Jonathan S. et al., Pyridinium-Derived N-Heterocyclic Carbene Complexes of Platinum: Synthesis, Structure and Ligand Substitution Kinetics, Journal of the American Chemical Society, 2004, 126(26), pages 8247 to 8255, compound 6c | 1-5<br>12-13<br>6-11 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 31 March, 2006 (31.03.06) | 11 April, 2006 (11.04.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2006/303548

C (Continuation). DOCUMENTS CONSIDERED TO BE RELEVANT

| Category* | Citation of document, with indication, where appropriate, of the relevant passages | Relevant to claim No. |
|---|---|---|
| X<br>Y<br>A | ALBENIZ, Ana C. et al., Facile reversible metalation in an agostic complex and hydrogenolysis of a metal aryl complex via a dihydrogen complex, Organometallics, 1992, 11(1), pages 242 to 249, compounds 2 to 6 | 1-5<br>12-13<br>6-11 |
| Y<br>A | JP 2004-506305 A (The Trustees of Princeton University),<br>26 February, 2004 (26.02.04),<br>Examples<br>& WO 2002/015645 A1 & EP 1325671 A1<br>& US 6911271 B1 | 12-13<br>1-11 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP HEISEI81096239655 A
- JP HEISEI71995183561 A
- JP HEISEI31991200289 A
- US 6097147 A
- WO 0141512 A
- US 20010025108 A
- US 20020182441 A
- JP 2002170684 A
- JP 2003123982 A
- JP 2003133074 A
- US 20030040627 A
- WO 0215645 A


### Non-patent literature cited in the description


- **C. W. TANG ; S. A. VANSLYKE.** *Applied Physics Letters,* 1987, vol. 51, 913
- **D. F. OBRIEN ; M. A. BALDO et al.** Improved energy transfer in electrophosphorescent devices. *Applied Physics letters,* 18 January 1999, vol. 74 (3), 442-444
- **M. A. BALDOETAL.** Very high-efficiency green organic light-emitting devices based on electrophosphorescence. *Applied Physics letters,* 05 July 1999, vol. 75 (1), 4-6
- **C- L. LEE ; R. R. DAS ; J-J. KIM.** *Chem. Mater,* 2004, vol. 16 (23), 4642
- **W. J. FINKENZELLER ; P. STOSSEL ; H. YERSIN.** *Chem. Physics Lett,* 2004, 289